# EUROPEAN PATENT SPECIFICATION

(11) **EP 4 099 608 B1**
(45) Date of publication and mention of the grant of the patent: **22.04.2026**
(21) Application number: 21815876.4
(22) Date of filing: 20.08.2021
(51) Int. Cl.: H04L 7/00, H03M 1/66, G06F 1/12, G06N 10/80, H03M 1/06

(54) **CLOCK SYNCHRONIZATION SYSTEM, METHOD FOR CONTROLLING SIGNAL SYNCHRONIZATION, AND STORAGE MEDIUM**
SYSTEM ZUR TAKTSYNCHRONISIERUNG, VERFAHREN ZUR STEUERUNG DER SIGNALSYNCHRONISIERUNG UND SPEICHERMEDIUM
SYSTÈME DE SYNCHRONISATION D'HORLOGE, PROCÉDÉ DE COMMANDE DE SYNCHRONISATION DE SIGNAL, ET SUPPORT DE STOCKAGE

(30) Priority: 19.04.2021 CN 202110420565
(43) Date of publication of application: 07.12.2022
(73) Proprietor: Tencent Technology (Shenzhen) Company Limited, Shenzhen, Guangdong, 518057 (CN)
(72) Inventor: ZHANG, Hualiang, Guangdong 518057 (CN); XI, Guanglei, Guangdong 518057 (CN); ZHANG, Mengyu, Guangdong 518057 (CN); LIU, Fuming, Guangdong 518057 (CN); YU, Qiaonian, Guangdong 518057 (CN); ZHENG, Yicong, Guangdong 518057 (CN); ZHANG, Shengyu, Guangdong 518057 (CN)
(74) Representative: Novagraaf International SA
(86) International application number: PCT/CN2021/113778
(87) International publication number: WO 2022/222330

(56) References cited:
- EP-A1- 2 991 229
- WO-A1-2020/178640
- CN-A- 109 828 631
- CN-A- 111 510 277
- CN-A- 113 132 077
- CN-U- 211 123 712
- US-A1- 2005 231 244
- US-A1- 2012 166 856
- US-A1- 2020 084 033
- US-A1- 2021 026 162
- US-A1- 2021 026 162
- US-A1- 2023 032 250
- DONOHUE RYAN: "Synchronization in Digital Logic Circuits", 5 May 2002 (2002-05-05), XP093004953, Retrieved from the Internet <URL:https://web.stanford.edu/class/ee183/handouts/synchronization_pres.pdf> [retrieved on 20221205]

## Description

### RELATED APPLICATION

The present disclosure claims priority to Chinese Patent Application No. 202110420565.5, entitled "SYSTEM FOR CLOCK SYNCHRONIZATION, METHOD FOR CONTROLLING SIGNAL SYNCHRONIZATION, AND STORAGE MEDIUM" and filed with the China National Intellectual Property Administration on April 19, 2021.

### FIELD OF THE TECHNOLOGY

The present disclosure relates to the field of control on quantum computers, and in particular, to clock synchronization and control of signal synchronization.

### BACKGROUND OF THE DISCLOSURE

In recent years, quantum science and technology develops rapidly, and has become a new frontier of revolution in science, technology, and industry. Superconducting quantum computing is widely accepted as one of the most feasible solutions for achieving practical quantum computation, and therefore attracts much attention. A superconducting quantum computer has a system operating under ultralow-temperature. A superconducting quantum chip serves as a core of the superconducting quantum computer, and controls qubits via pulses with a frequency in the microwave band. Since microwave electronic devices may be manufactured through existing semiconductor microfabrication techniques, the superconducting quantum computer becomes a reliable candidate among physical systems that can implement quantum computation at present.

The core of the superconducting quantum computer is a quantum chip and a quantum control-and-measurement system. The quantum control-and-measurement system mainly includes an analog-to-digital conversion (ADC) module and a digital-to-analog conversion (DAC) module. A trigger signal is required to implement synchronization among multiple modules. The trigger signal is independently generated from a module, and is transmitted to different ADC or DAC modules via coaxial cables of identical lengths, so as to synchronize these modules.

The trigger signal is generated by a field programmable gate array (FPGA) chip, and has a high jitter in comparison with a signal generated by a clock chip.

US20210026162A1 describes a scalable and programmable coherent waveform generator implemented for quantum information processing (QIP) systems. CN111510277A describes a multi-channel signal synchronization system for signal synchronization in the multi-channel system.

### SUMMARY

A system for clock synchronization, a method for controlling signal synchronization control, and a storage medium are provided according to embodiments of the present disclosure. After a signal for global synchronization enters a signal synchronization module in a digital-analog inter-converter, the signal for global synchronization is relocked based on a target clock signal having a low jitter via one or more D flip-flops (DFFs), thereby reducing signal delay and improving precision of signal synchronization.

In view of the above, a system for clock synchronization is provided according to an aspect of the present disclosure. The system includes a quantum control processor (QCP) and N digital-analog inter-converters, where each digital-analog inter-converter includes a frequency conversion module and a signal synchronization module, the signal synchronization module includes at least one DFF, and N is an integer greater than 1.

The QCP is configured to generate a signal for global synchronization and N reference clock signals, and each reference clock signal corresponds to one of the digital-analog inter-converters.

The QCP is further configured to transmit the signal for global synchronization and each reference clock signal to the frequency conversion module in the corresponding digital-analog inter-converter, and transmit the signal for global synchronization to the signal synchronization module in each digital-analog inter-converter.

The frequency conversion module is configured to perform frequency conversion on the received reference clock signal to obtain a target clock signal, and generate an instruction for signal synchronization according to the received global synchronization signal.

The frequency conversion module is further configured to transmit the instruction for signal synchronization and the target clock signal to the signal synchronization module.

The signal synchronization module is configured to perform, in response to the instruction for signal synchronization and based on the signal for global synchronization, signal synchronization on the target clock signal under control of a new signal synchronization signal, which is obtained by stabilizing the signal for global synchronization with reference to the target clock signal via the at least one DFF, to obtain a synchronized clock signal.

A method for controlling signal synchronization is provided according to another aspect of the present disclosure. The method is applied to a system for clock synchronization, where the system includes a quantum control processor (QCP) and N digital-analog inter-converters, each digital-analog inter-converter includes a frequency conversion module and a signal synchronization module, the signal synchronization module includes at least one DFF, and N is an integer greater than 1. The method includes:
generating, by the QCP, a signal for global synchronization and N reference clock signals where each reference clock signal corresponds to one of the digital-analog inter-converters;
transmitting, by the QCP, the signal for global synchronization and each reference clock signal to the frequency conversion module in the corresponding digital-analog inter-converter;
transmitting, by the QCP, the signal for global synchronization to the signal synchronization module in each digital-analog inter-converter;
performing, by the frequency conversion module, frequency conversion on the received reference clock signal to obtain a target clock signal;
generating, by the frequency conversion module, an instruction for signal synchronization according to the received global synchronization signal;
transmitting, by the frequency conversion module, the instruction for signal synchronization and the target clock signal to the signal synchronization module; and
performing, by the signal synchronization module in response to the instruction for signal synchronization and based on the signal for global synchronization, signal synchronization on the target clock signal via the at least one DFF, to obtain a synchronized clock signal.

A computer-readable storage medium is provided according to another aspect of the present disclosure. The computer-readable storage medium stores a computer program, and the computer program is configured to perform the method according to the foregoing aspect.

A computer program product or a computer program is provided according to another aspect of the present disclosure. The computer program product or the computer program including computer instructions stored in a computer-readable storage medium. The computer instructions, when being read from the computer-readable storage medium and executed by a processor of a computer device, configure the computer device to perform the method according to the foregoing aspect.

According to the foregoing technical solutions, embodiments of the present disclosure have following advantages.

A system for clock synchronization is provided according to embodiments of the present disclosure. The system includes the QCP and the N digital-analog inter-converters, each digital-analog inter-converter includes the frequency conversion module and the signal synchronization module, and the signal synchronization module includes the at least one DFF. The QCP generates the signal for global synchronization and the N reference clock signals, then transmits the signal for global synchronization and each reference clock signal to the frequency conversion module in the corresponding digital-analog inter-converter, and transmits the signal for global synchronization to the signal synchronization module in each digital-analog inter-converter. The frequency conversion module performs frequency conversion on the received reference clock signal to obtain the target clock signal, generates the instruction for signal synchronization according to the received global synchronization signal, and then transmits the instruction for signal synchronization and the target clock signal to the signal synchronization module. The signal synchronization module performs, in response to the instruction for signal synchronization and based on the signal for global synchronization, signal synchronization on the target clock signal via the at least one DFF, so as to obtain the synchronized clock signal. According to the foregoing system, after the signal for global synchronization enters the signal synchronization module in the digital-analog inter-converter, the target clock signal is relocked based on a low-jitter reference clock signal via one or more DFFs, thereby reducing signal delay and improving precision of signal synchronization.

### BRIEF DESCRIPTION OF THE DRAWINGS

Figure 1 is a schematic diagram of a basic experimental platform of a superconducting quantum computer according to an embodiment of the present disclosure.
Figure 2 is a schematic structural diagram of a quantum control-and-measurement system according to an embodiment of the present disclosure.
Figure 3 is a schematic structural diagram of a system for clock synchronization according to an embodiment of the present disclosure.
Figure 4 is a schematic diagram of signal processing implemented based on multiple stages of DFFs according to an embodiment of the present disclosure.
Figure 5 is a schematic structural diagram of an arbitrary waveform generator (AWG) based on a system for clock synchronization according to an embodiment of the present disclosure.
Figure 6 is a schematic structural diagram of another AWG based on a system for clock synchronization according to an embodiment of the present disclosure.
Figure 7 is a schematic structural diagram of another AWG based on a system for clock synchronization according to an embodiment of the present disclosure.
Figure 8 is a schematic structural diagram of a digital acquisition device (DAQ) based on a system for clock synchronization according to an embodiment of the present disclosure.
Figure 9 is a schematic structural diagram of another DAQ based on a system for clock synchronization according to an embodiment of the present disclosure.
Figure 10 is a schematic structural diagram of another DAQ based on a system for clock synchronization according to an embodiment of the present disclosure.
Figure 11 is a schematic structural diagram of another system for clock synchronization according to an embodiment of the present disclosure.
Figure 12 is a schematic structural diagram of another AWG based on a system for clock synchronization according to an embodiment of the present disclosure.
Figure 13 is a schematic structural diagram of another AWG based on a system for clock synchronization according to an embodiment of the present disclosure.
Figure 14 is a schematic structural diagram of another AWG based on a system for clock synchronization according to an embodiment of the present disclosure.
Figure 15 is a schematic structural diagram of another DAQ based on a system for clock synchronization according to an embodiment of the present disclosure.
Figure 16 is a schematic structural diagram of another DAQ based on a system for clock synchronization according to an embodiment of the present disclosure.
Figure 17 is a schematic structural diagram of another DAQ based on a system for clock synchronization according to an embodiment of the present disclosure.
Figure 18 is a schematic structural diagram of a chassis based on a system for clock synchronization according to an embodiment of the present disclosure.
Figure 19 is a schematic structural diagram of another chassis based on a system for clock synchronization according to an embodiment of the present disclosure.
Figure 20 is a schematic structural diagram of multiple cascading systems for clock synchronization according to an embodiment of the present disclosure.
Figure 21 is a schematic timeline of signal synchronization according to an embodiment of the present disclosure.
Figure 22 is a schematic flowchart of signal synchronization according to another embodiment of the present disclosure.
Figure 23 is a schematic flowchart of a method for controlling signal synchronization according to an embodiment of the present disclosure.

### DESCRIPTION OF EMBODIMENTS

A system for clock synchronization, a method for controlling signal synchronization control, and a storage medium are provided according to embodiments of the present disclosure. After a signal for global synchronization enters a signal synchronization module in a digital-analog inter-converter, a target clock signal is relocked based on a reference clock signal having a low jitter via one or more D flip-flops (DFFs), thereby reducing signal delay and improving precision of signal synchronization.

The terms such as "first", "second", "third", and "fourth" (if any) in specification, the drawings ,and claims of the present disclosure are intended for distinguishing similar objects, and are not necessarily used to describe any particular order or sequence. It should be understood that data described in this way is exchangeable in a proper case, so that embodiments of the present disclosure can be implemented in an order different from the order shown or described herein. In addition, the terms "include", "corresponding to" and any other variants are intended for covering the non-exclusive inclusion. For example, a process, a method, a system, a product, or a device that includes a series of steps or units is not necessarily limited to those expressly listed steps or units, but may include another step or another unit which is not expressly listed or which is inherent to such process, method, product, or device.

Combination of quantum mechanics and classic information science generate a new discipline, i.e. quantum information science, which mainly includes fields such as quantum communication and quantum computation. In recent years, quantum information technology, where quantum communication technology as representative, attracts great attention in both science and engineering due to its tremendous potential in application and significance in science. Quantum properties lead to unique functions in the information field, and may break limits on classic information systems in, for example, improving computation speed, ensuring information security, increasing information capacities, and improving detection precision. Therefore, quantum information science. As a compound of quantum mechanics and information science, the quantum information science becomes a new branch of disciplines, and includes quantum cryptography, quantum communication, quantum computation, quantum measurement, and the like.

The quantum computation is widely applied. In biological medicine, principles of molecular interaction and chemical reaction may be obtained through simulation on a quantum computer, so as to find new materials and develop new medicines. Moreover, the quantum computation may be applied to gene sequencing and gene analyses, thereby helping people learn about gene expression through large-scale analyses and machine learning. In big data, the quantum computation allows parallel computation due to its "superposition" property, and thereby can accelerate some classic algorithms and have variously applications. In financial engineering, the quantum computation is capable of fast analysis on a large amount of data and fast operation, and thereby can meet a requirement on high-frequency trading. In addition, the quantum computation may be applied to asset and risk management. Since construction and management of financial investment combinations requires considering and analyzing a large amount of technical data to determine various strategies, many algorithms of the quantum computation may be applied to combinatorial optimization on financial products. In aeronautics and astronautics, the quantum computation can solve industrial problems, for example, can classify and analyze satellite images, and fabricate novel materials for airplanes.

In practice, there are various solutions for implementing quantum computation, among which the superconducting quantum computation is most promising for a general-purpose quantum computer due to properties such as long coherence times, good expandability, and high precision in control and measurement. Quantum computation is mainly implemented through a quantum computer, which is a physical device that performs mathematical and logical operations, storage, and quantum information processing at a high speed under laws of the quantum mechanics. A core of the quantum computer is a quantum chip and a quantum control-and-measurement system. The quantum control-and-measurement system generates a corresponding pulse signal for quantum control, based on a designed quantum circuit. The analog signal is coupled with a physical substrate, into which qubits are embedded, through an electromagnetic field, so as to control operation of the quantum computer.

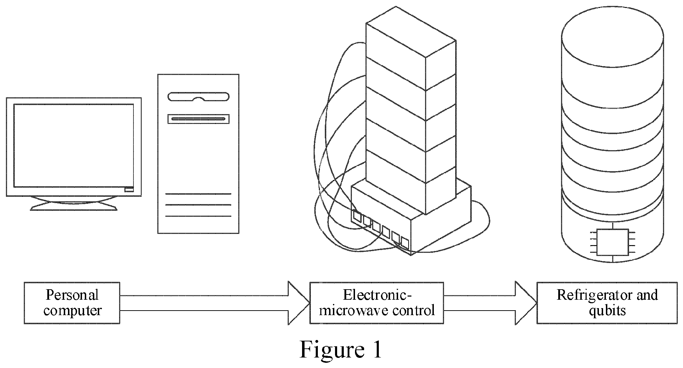

The system for clock synchronization and the method for controlling signal synchronization according to embodiments of the present disclosure are applicable to the quantum control-and-measurement system in quantum computation, a superconducting quantum computer, or another physical quantum computation platform. Hence, a technical foundation would be laid for large-scale quantum computation. In order to facilitate understanding, reference is made to Figure 1, which is a schematic diagram of a basic experimental platform of a superconducting quantum computer according to an embodiment of the present disclosure. As shown in Figure 1, an exemplary superconducting quantum computation platform mainly includes a superconducting quantum chip under a temperature approximating absolute zero, a dilution refrigerator, a microwave electronics system configured to control a qubit, and a personal computer (PC) terminal configured to control the electronics system. A quantum program is compiled into an instruction through software at the PC side. The instruction is transmitted to an electronic-microwave control system and is electronically converted into a microwave signal, and the signal is transmitted into the dilution refrigerator, to control a superconducting qubit under a temperature less than 10 millikelvins (mK). A read process is an inverse of the foregoing process, namely, a read waveform is transmitted to the quantum chip.

Some technical terms may be present in the present disclosure. In order to facilitate understanding, hereinafter the technical terms are described.
(1) Quantum computation (QC) refers to using superposition and entanglement properties of quantum states to complete a specific computation task rapidly.
(2) A physical qubit refers to a qubit implemented by a real physical device, and includes a data qubit and an ancilla qubit.
(3) A field programmable gate array (FPGA) chip refers to a semi-custom circuit in application-specific integrated circuits, and is a programmable logic array capable of solving effectively a problem that a quantity of gates is small in a conventional device. The FPGA adopts a concept of logic cell array (LCA), and include three internal parts, i.e. a configurable logic block (CLB), an input output block (IOB), and an interconnect (Interconnect).
(4) An analog-to-digital conversion (ADC) channel refers to a device configured to convert a continuous analog signal into a discrete digital signal.
(5) A digital-to-analog conversion (DAC) channel refers to a device configured to a digital signal into an analog signal (of which a form is a current, a voltage, or a charge).
(6) An arbitrary waveform generator (AWG) refers to a device configured to receive a waveform of a digital signal, and generates a corresponding analog waveform through digital-to-analog conversion. The AWG in a quantum control-and-measurement system is configured to generate a waveform configured to control and read a qubit.
(7) A digital acquisition unit (DAQ) refers to a device configured to receive an inputted analog signal, and obtain a corresponding digital signal through analog-to-digital conversion, where the digital signal is for various subsequent processing. The DAQ in a quantum control-and-measurement system is configured to receive a result of reading a quantum chip.
(8) A quantum control processor (QCP) refers to a module configured to execute instructions for controlling qubits, receive a result from a DAQ in an experiment, and controls an AWG to transmit a waveform corresponding to a quantum operation. The QCP in a quantum control-and-measurement system controls program flow and feedback, through real-time processing on instructions generated by a program for controlling qubits.
(9) A quantum control-and-measurement system refers to a system configured to execute a quantum program through running a quantum instruction set, provide an input signal to a quantum chip for control, and perform measurement on the quantum chip to acquire a result. Generally, the quantum control-and-measurement system for superconducting quantum computation includes an AWG, a DAQ, and a QCP.
(10) An inter-channel skew refers to a case in which different channels transmit signals simultaneously and phases of the signals are aligned at an output end.
(11) A D flip-flop (DFF) refers to a flip-flop that has an input, an output, and a clock input. When the clock input changes from 0 to 1, a value at the output is set to be a value at the input. The D flip-flop may be used to prevent an error caused by noise.
(12) An advanced telecom computing architecture (ATCA) refers to architecture originating from a new-generation mainstream industrial computation technology, which is widely applied to fields such as telecom, astronautics, industrial control, medical appliances, intelligent transportation, and military equipment.
(13) A phase locked loop (PLL) refers to A PLL is a system for controlling frequency and phase, which is implemented based on a feedback control principle. The PLL is configured to keep a signal outputted by a circuit in synchronization with a reference signal independent from the circuit. In case of a change in a frequency or a phase of the reference signal, the PLL can detect the change and regulate an output frequency through a feedback system inside the circuit, until the signal and the reference signal are resynchronized. Such synchronization is also called "phase-locked".
(14) A voltage-controlled oscillator (VCO) refers to an electronic oscillation circuit designed to control an oscillating frequency based on a voltage input. The VCO is an oscillation circuit of which an outputted frequency corresponds to an inputted control voltage, namely, is an oscillator of which a frequency is a function of a voltage of an input signal. The VCO may be achieved when an operation state of an oscillator or a component parameter of an oscillation loop is controlled by an input control voltage.
(15) A divider and delay unit (Div/Dly) refers to a divider unit and a delay unit. The divider unit refers to a circuit that can process the input signal to achieve a relationship of fout = fin/N, where N is an integer, between a frequency (fin) of the input signal fin and a frequency (fout) of an output signal. A delay unit refers to a circuit that delays an input signal by a specific period.
(16) Gmon refers to superconducting qubit architecture combining a highly-coherent qubit and tunable qubit-to-qubit coupling.
(17) In-phase (I) refers to an in-phase signal in in-phase quadrature (IQ) signals.
(18) Quadrature (Q) refers to a quadrature signal in the IQ signals. A phase difference between the quadrature signal and the in-phase signal is 90 degrees.
(19) A local oscillator signal is abbreviated as LO.
(20) A baseband signal is abbreviated as BB.
(21) A radio frequency signal is abbreviated as RF.

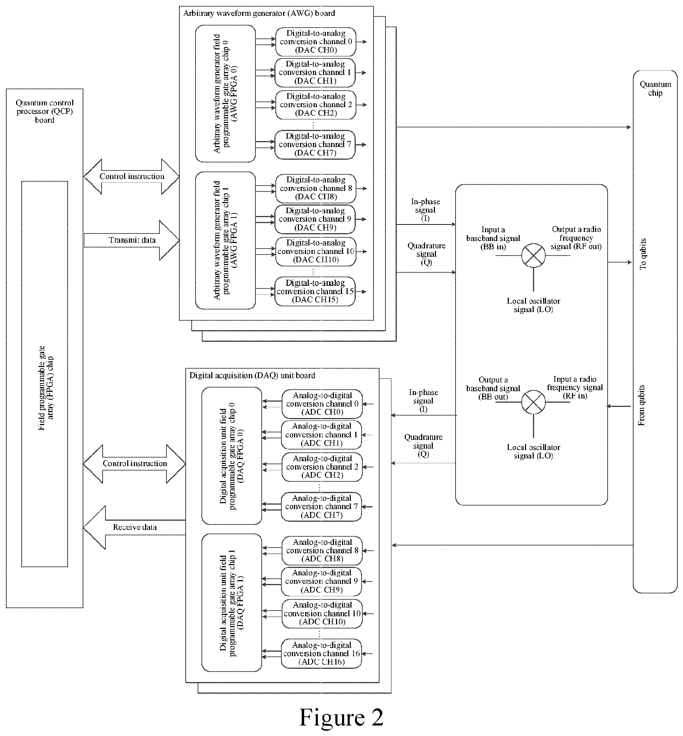

With reference to the foregoing description, hereinafter described is a quantum control-and-measurement system according to embodiments of the present disclosure. Reference is made to Figure 2, which is a schematic structural diagram of a quantum control-and-measurement system according to an embodiment of the present disclosure. As shown in Figure 2, multiple AWG boards, multiple DAQ boards, and a QCP board are integrated in the quantum control-and-measurement system. Each DAQ board includes multiple ADC channels and multiple FPGA chips, and each AWG board includes multiple DAC channels and multiple FPGA chips. The QCP is capable to control the DAQs and the AWGs, and a quantity of the DAQs and a quantity of the AWGs are determined according to a chip structure and a quantity of qubits that need to be controlled and measured. For example, 18 AWGs, 2 DAQs, and 1 QCP are required to support a 56-bit Gmon.

In the quantum control-and-measurement system as shown in Figure 2, data at outputs of different ADC channels and waveforms at outputs of different DAC channels need to be synchronized among all the modules. Thus, an integration system that keeps different data or waveforms of multiple channels in cross-module synchronization is a challenge for a designer. Generally, the synchronization has following three cases. A first case is that all ADC channels in the system need to sample multiple inputs simultaneously, or sample inputs based on a known phase relationship. A second case is that all DAC channels in the system need to output waveforms simultaneously, or waveforms outputted from different channels are maintained in a fixed phase relationship that is known. A third case is that the ADC channels and the DAC channels in the system need to sample inputs based on a fixed phase relationship that is known.

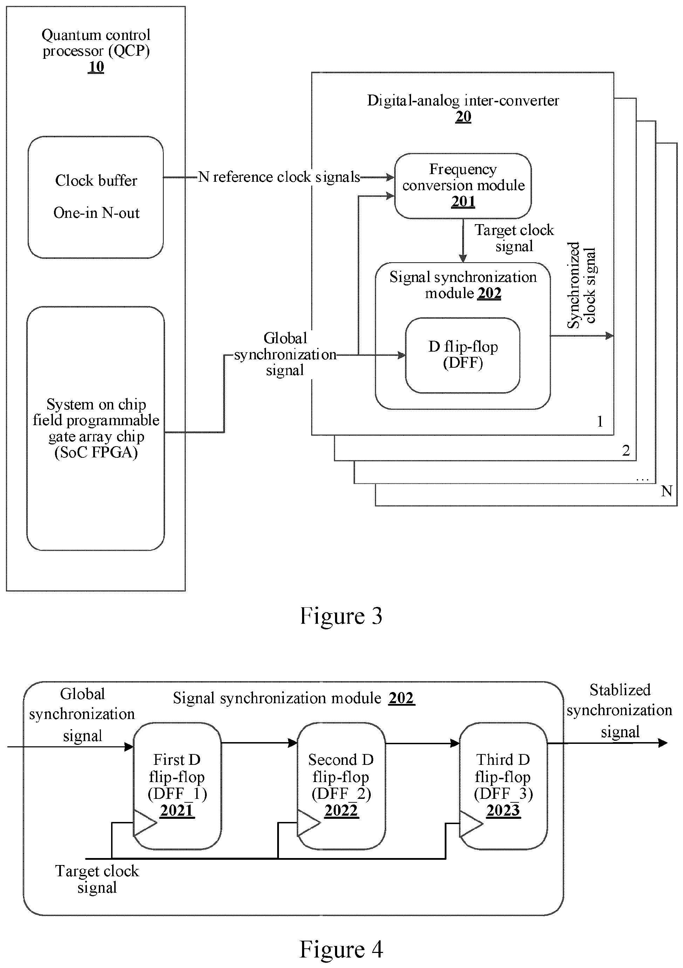

On basis of the above, a system for clock synchronization is further provided according to embodiments of the present disclosure. Different modules in the foregoing system are organically integrated in time sequence, based on the synchronization scheme. Hereinafter illustrated in the system for clock synchronization according to an embodiment of the present disclosure. Reference is made to Figure 3, which is a schematic diagram of an embodiment of a system for clock synchronization according to an embodiment of the present disclosure. As shown in Figure 3, the system for clock synchronization includes a QCP 10 and N digital-analog inter-converters 20. Each digital-analog inter-converter 20 includes a frequency conversion module 201 and a signal synchronization module 202, the signal synchronization module 202 includes at least one DFF, and N is an integer greater than 1.

The QCP 10 is configured to generate a signal for global synchronization and N reference clock signals. Each reference clock signal corresponds to one of the digital-analog inter-converters 20.

The QCP 10 is further configured to transmit the signal for global synchronization and each reference clock signal to the frequency conversion module 201 in the corresponding digital-analog inter-converter 20, and transmit the signal for global synchronization to the signal synchronization module 202 in each digital-analog inter-converter 20.

The frequency conversion module 201 is configured to perform frequency conversion on the received reference clock signal to obtain a target clock signal, and generate an instruction for signal synchronization according to the received global synchronization signal.

The frequency conversion module 201 is further configured to transmit the instruction for signal synchronization and the target clock signal to the signal synchronization module 202.

The signal synchronization module 202 is configured to perform signal synchronization on the target clock signal via the at least one DFF, in response to the instruction for signal synchronization and based on the signal for global synchronization, so as to obtain a synchronized clock signal.

In this embodiment, the system for clock synchronization is a quantum control-and-measurement system having clock synchronization. The N digital-analog inter-converters include at least one AWG and at least one DAQ. In Figure 3, the digital-analog inter-converter corresponds to the AWG (or the DAQ) in Figure 2, and the frequency conversion module and the signal synchronization module in the digital-analog inter-converter are independent from the AWG FPGA chip (or the DAQ FPGA chip) as shown in Figure 2.

In one embodiment, the QCP includes a clock buffer and a system on chip FPGA (SoC FPGA) chip. The clock buffer has one input and N outputs, namely, the clock buffer may output N reference clock signals (REFCLKs), so that each digital-analog inter-converter corresponds to one REFCLK. The SoC FPGA chip outputs a signal for global synchronization (global synchronization signal, Sync_GLB), and the N digital-analog inter-converters all use the uniform Sync_GLB. For each digital-analog inter-converter, the QCP transmits the Sync_GLB and the corresponding REFCLK to the frequency conversion module, and transmits the Sync_GLB to the signal synchronization module.

Hereinafter an arbitrary digital-analog inter-converter is taken as an example. The frequency conversion module in such digital-analog inter-converter performs frequency conversion on the received REFCLK to obtain a target clock signal different from the REFCLK, and generates an instruction for signal synchronization according to the received Sync_GLB. Accordingly, the frequency conversion module transmits the instruction for signal synchronization and the target clock signal to the signal synchronization module. In response to the instruction for signal synchronization, the signal synchronization module locks the Sync_GLB to the clock signal having a low jitter, via one or more stages of DFFs, to obtain a new synchronization signal having a low jitter.

The system for clock synchronization is provided according to embodiments of the present disclosure. In such system, after the signal for global synchronization enters the signal synchronization module in the digital-analog inter-converter, the signal for global synchronization is relocked to the target clock signal having the low jitter, via one or more DFFs, and thereby meta-stability therein is less possible. A jitter of the synchronization signal is suppressed, and hence the signal synchronization is more precise.

Reference is further made to Figure 4 on a basis of Figure 3. Figure 4 is a schematic diagram of implementing signal processing based on multiple stages of DFFs according to an embodiment of the present disclosure. Another embodiment of the present disclosure is provided by combining Figure 3 and Figure 4. The signal synchronization module 202 includes a first DFF 2021, a second DFF 2022, and a third DFF 2023. The first DFF 2021 is coupled to the second DFF 2022, and the second DFF 2022 is coupled to the third DFF 2023.

In this embodiment, multiple DFFs cascade in the signal synchronization module to reduce probability of meta-stability. The meta-stability refers to a signal not reaching the stable "0" or "1" within at a certain period during normal operation. In a multi-clock design, the meta-stability is inevitable. Hence, it is necessary to suppress the generation and spread of the meta-stability, and eliminate harmful effects due to the meta-stability. Before being stabilized, a meta-stable output may be a glitch, oscillation, or a fixed voltage. Hence, the meta-stable output may result in not only logic misjudgment, but also meta-stability in a next stage since the outputted voltage is between "0" and "1" (namely, spread of the meta-stability is expected).

In view of the above, multiple stages of DFFs are provided in the signal synchronization module. In order to facilitate understanding, reference is made to Figure 4 again. As shown in Figure 4, the Sync_GLB and the target clock signal, which is outputted from the frequency conversion module, are inputted from outside. With the help of the first to the third DFFs, the Sync_GLB is stabilized based on the target clock signal, and the target clock signal is synchronized by using the stabilized Sync_GLB, so as to obtain a synchronized clock signal.

According to this embodiment, multiple DFFs are disposed in the signal synchronization module in the system for clock synchronization. In such structure, after the first DFF samples an asynchronous input, meta-stability would be tolerated for a clock period, and a meta-stable characteristic is weakened in such clock period. Similarly, the second DFF and the third DFF is capable to further reduce a probability of meta-stability. Accordingly, the probability of meta-stability of an asynchronous signal can be greatly reduced via the three stages of DFFs.

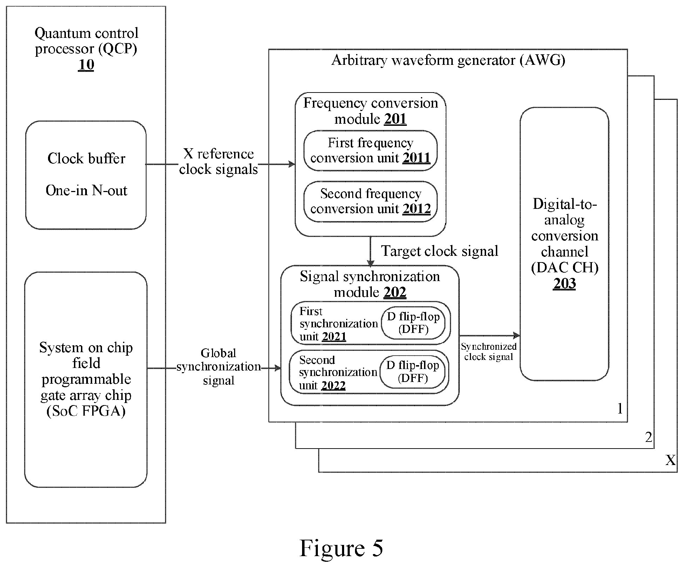

Reference is further made to Figure 5 on a basis of Figure 3. Figure 5 is a schematic structural diagram of an AWG based on a system for clock synchronization AWG according to an embodiment of the present disclosure. Another embodiment of the present disclosure is provided by combining Figure 3 and Figure 5. The N digital-analog inter-converters 20 include an AWG. The AWG belongs to one of the digital-analog inter-converters 20, and includes a DAC channel 203. The frequency conversion module 201 includes a first frequency conversion unit 2011 and a second frequency conversion unit 2012. The signal synchronization module 202 includes a first synchronization unit 2021 and a second synchronization unit 2022. The first synchronization unit 2021 includes at least one DFF, and the second synchronization unit 2022 includes at least one DFF.

The first frequency conversion unit 2011 is configured to perform frequency conversion on the received REFCLK to obtain a first-frequency clock sub-signal, and generate a first synchronization instruction according to the received global synchronization signal. The target clock signal includes the first-frequency clock sub-signal, and the instruction for signal synchronization includes the first synchronization instruction.

The first frequency conversion unit 2011 is further configured to transmit the first synchronization instruction and the first-frequency clock sub-signal to the first synchronization unit 2021.

The first synchronization unit 2021 is configured to perform signal synchronization on the first-frequency clock sub-signal via the at least one DFF in the first synchronization unit 2021, in response to the first synchronization instruction and based on the signal for global synchronization, to obtain a first synchronized clock sub-signal. The synchronized clock signal includes the first synchronized clock sub-signal.

The first synchronization unit 2021 is optionally configured to transmit the first synchronized clock sub-signal to the second frequency conversion unit 2012.

The second frequency conversion unit 2012 is configured to perform frequency conversion on and delay the received first synchronized clock sub-signal to obtain a second-frequency clock sub-signal, and generate a second synchronization instruction according to the received global synchronization signal. The target clock signal includes the second-frequency clock sub-signal, and the instruction for signal synchronization includes the second synchronization instruction.

The second frequency conversion unit 2012 is further configured to transmit the second synchronization instruction and the second-frequency clock sub-signal to the second synchronization unit 2022.

The second synchronization unit 2022 is configured to perform signal synchronization on the second-frequency clock sub-signal via the at least one DFF in the second synchronization unit 2022, in response to the second synchronization instruction and based on the signal for global synchronization, to obtain a second synchronized clock sub-signal. The synchronized clock signal includes the second synchronized clock sub-signal.

The second synchronization unit 2022 is optionally configured to transmit the second synchronized clock sub-signal to the DAC channel 203. The second synchronized clock sub-signal is preferably a digital signal.

The DAC channel 203 is preferably configured to convert the second synchronized clock sub-signal into an analog signal.

In this embodiment, an AWG in the digital-analog inter-converters is taken as an example. The AWG includes a first frequency conversion unit and a second frequency conversion unit. In one embodiment, the first frequency conversion unit may be a PLL and a VCO (PLL/VCO), and the second frequency conversion unit may be a Div/Dly. Accordingly, the signal synchronization module includes a first synchronization unit and a second synchronization unit. The first frequency conversion unit may be built in the first synchronization unit, or the first frequency conversion unit and the first synchronization unit are connected in communication. Similarly, the second frequency conversion unit may be built in the second synchronization unit, or the second frequency conversion unit and the second synchronization unit are connected in communication.

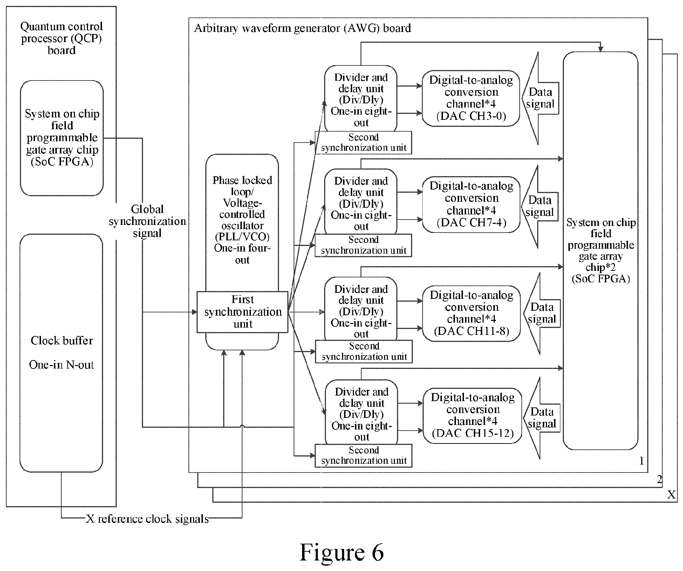

Hereinafter it is taken as an example that the first frequency conversion unit is a PLL/VCO and the second frequency conversion unit is a Div/Dly. In order to facilitate understanding, reference is made to Figure 6, which is a schematic structural diagram of another AWG based on a system for clock synchronization according to an embodiment of the present disclosure. As shown in Figure 6, it is assumed that there are X AWGs, each of which corresponds to a REFCLK. Namely, there are X REFCLKs in total. X is an integer greater than or equal to 1 and less than N. The PLL/VCO performs frequency conversion on the received REFCLK to obtain the first-frequency clock sub-signal, and generates the first synchronization instruction according to the received Sync_GLB. Then, the PLL/VCO then transmits the first synchronization instruction and the first-frequency clock sub-signal to the first synchronization unit. The first synchronization unit performs signal synchronization on the first-frequency clock sub-signal via a DFF, in response to the first synchronization instruction and based on the Sync_GLB, so as to output the first synchronized clock sub-signal.

Optionally, the first synchronization unit transmits the first synchronized clock sub-signal to the Div/Dly. The Div/Dly performs frequency conversion on the received first synchronized clock sub-signal and delay the received first synchronized clock sub-signal, so as to obtain the second-frequency clock sub-signal. The Div/Diy generates the second synchronization instruction according to the received Sync_GLB. Then, the Div/Dly then transmits the second synchronization instruction and the second-frequency clock sub-signal to the second synchronization unit. The second synchronization unit performs signal synchronization on the second-frequency clock sub-signal via a DFF, in response to the second synchronization instruction and based on the Sync_GLB, so as to output the second synchronized clock sub-signal.

Finally, the second synchronization unit optionally transmits the second synchronized clock sub-signal to the DAC channel. The second synchronized clock sub-signal is preferably a digital signal. Each Div/Dly as shown in Figure 6 corresponds to 4 DAC channels, and each DAC channel has two inputs. Preferably, the DAC channel converts the second synchronized clock sub-signal into the analog signal.

An input of the DFF corresponding to the PLL/VCO is the Sync_GLB, and the target clock signal corresponding to the PLL/VCO is a clock signal outputted from the VCO. The target clock signal corresponding to the Div/Diy is a clock signal inputted into the Div/Diy. New synchronization signals are generated from one or more stages of DFFs, and are used to synchronize outputs from the frequency dividers in the system.

In this embodiment, the configurable second frequency conversion unit, namely, the Div/Dly is added to an input end of each DAC channel in the system for clock synchronization. Thereby, a phase of a signal outputted by each DAC channel is independent and tunable, reducing an inter-channel phase skew due to differences in wirings and components of a printed circuit board (PCB).

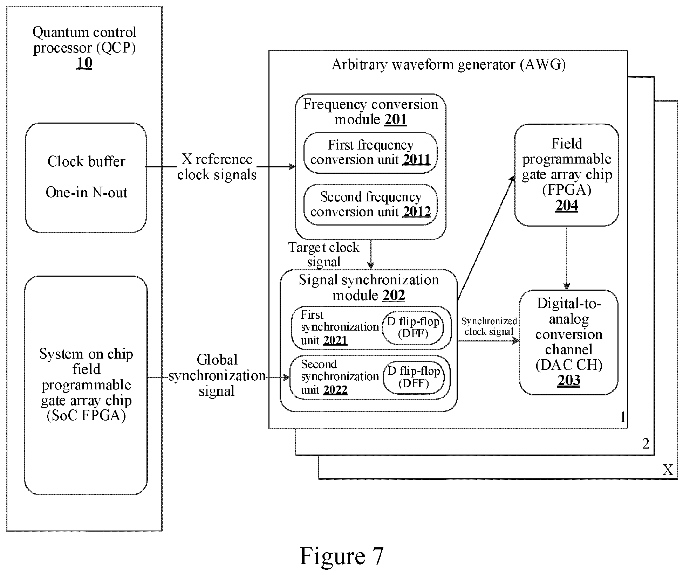

Reference is made to Figure 7 on a basis of Figure 3. Figure 7 is a schematic structural diagram of another AWG based on a system for clock synchronization according to an embodiment of the present disclosure. Another embodiment of the present disclosure is provided by combining Figure 3 and Figure 7. The AWG in the system for clock synchronization further includes an FPGA chip 204.

The second synchronization unit 2022 is optionally configured to transmit the second synchronized clock sub-signal to the FPGA chip 204.

The FPGA chip 204 is configured to transmit a data signal to the DAC channel 203, under control of the second synchronized clock sub-signal.

In this embodiment, the AWG in the digital-analog inter-converters is taken as an example. The AWG includes a first frequency conversion unit and a second frequency conversion unit. In one embodiment, the first frequency conversion unit may be a PLL and a VCO (PLL/VCO), and the second frequency conversion unit may be a Div/Dly. Accordingly, the signal synchronization module includes a first synchronization unit and a second synchronization unit. The first frequency conversion unit may be built in the first synchronization unit, or the first frequency conversion unit and the first synchronization unit are connected in communication. Similarly, the second frequency conversion unit may be built in the second synchronization unit, or the second frequency conversion unit and the second synchronization unit are connected in communication.

In view of the above, hereinafter it is taken as an example that the first frequency conversion unit is a PLL/VCO and the second frequency conversion unit is a Div/Dly. In order to facilitate understanding, reference is further made to Figure 6, which is a schematic structural diagram of another AWG based on a system for clock synchronization according to an embodiment of the present disclosure. As shown in Figure 6, the second synchronization unit may further transmit the second synchronized clock sub-signal, of which the frequency has been converted, to the FPGA chip. The FPGA chip determines, based on the second synchronized clock sub-signal, that clock synchronization has been achieved, and hence transmits the data signal to the DAC channel.

In this embodiment, since the Div/Dly has a function of frequency conversion in the system for clock synchronization, the signal of which the frequency has been converted may be further transmitted to the FPGA chip. It is not necessary to arrange an additional device to perform the frequency conversion, thereby improving a degree of integration.

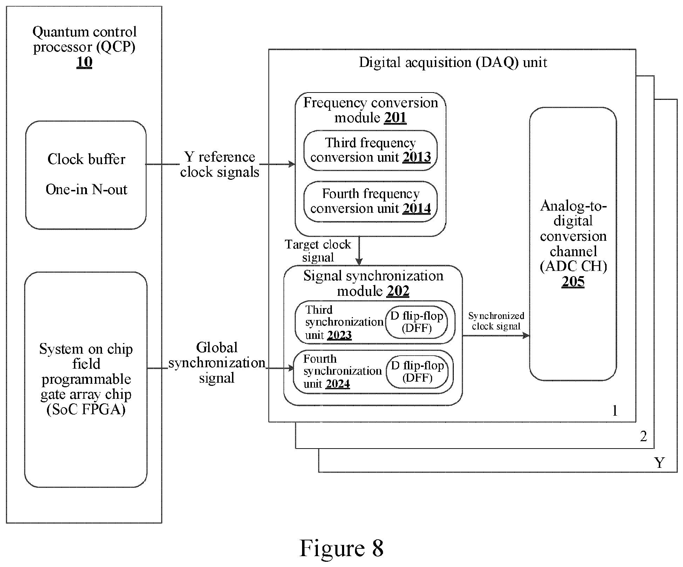

Reference is made to Figure 8 on a basis of Figure 3. Figure 8 is a schematic structural diagram of a DAQ based on a system for clock synchronization according to an embodiment of the present disclosure. Another embodiment of the present disclosure is provided by combining Figure 3 and Figure 8. The N digital-analog inter-converters 20 include a DAQ. The DAQ is one of the digital-analog inter-converters 20, and includes an ADC channel 205. The frequency conversion module 201 includes a third frequency conversion unit 2013 and a fourth frequency conversion unit 2014. The signal synchronization module 202 includes a third synchronization unit 2023 and a fourth synchronization unit 2024. The third synchronization unit 2023 includes at least one DFF, and the fourth synchronization unit 2024 includes at least one DFF.

The third frequency conversion unit 2013 is configured to perform frequency conversion on the received REFCLK to obtain a third-frequency clock sub-signal, and generate a third synchronization instruction according to the received global synchronization signal. The target clock signal includes the third-frequency clock sub-signal, and the instruction for signal synchronization includes the third synchronization instruction.

The third frequency conversion unit 2013 is further configured to transmit the third synchronization instruction and the third-frequency clock sub-signal to the third synchronization unit.

The third synchronization unit 2023 is configured to perform signal synchronization on the third-frequency clock sub-signal via the at least one DFF in the third synchronization unit 2023, in response to the third synchronization instruction and based on the signal for global synchronization, to obtain a third synchronized clock sub-signal. The synchronized clock signal includes the third synchronized clock sub-signal.

The third synchronization unit 2023 is optionally configured to transmit the third synchronized clock sub-signal to the fourth frequency conversion unit 2014.

The fourth frequency conversion unit 2014 is configured to perform frequency conversion on and delay the received third synchronized clock sub-signal to obtain a fourth-frequency clock sub-signal, and generate a fourth synchronization instruction according to the received global synchronization signal. The target clock signal includes the fourth-frequency clock sub-signal, and the instruction for signal synchronization includes the fourth synchronization instruction.

The fourth frequency conversion unit 2014 is further configured to transmit the fourth synchronization instruction and the fourth-frequency clock sub-signal to the fourth synchronization unit 2024.

The fourth synchronization unit 2024 is configured to perform signal synchronization on the fourth-frequency clock sub-signal via the at least one DFF in the fourth synchronization unit 2024, in response to the fourth synchronization instruction and based on the signal for global synchronization, to obtain a fourth synchronized clock sub-signal. The synchronized clock signal includes the fourth synchronized clock sub-signal.

The fourth synchronization unit 2024 is optionally configured to transmit the fourth synchronized clock sub-signal to the ADC channel 205. The fourth synchronized clock sub-signal is preferably an analog signal.

The ADC channel 205 is preferably configured to convert the fourth synchronized clock sub-signal into a digital signal.

In this embodiment, the DAQ in the digital-analog inter-converters is taken as an example. The DAQ includes the third frequency conversion unit and the fourth frequency conversion unit. In one embodiment, the third frequency conversion unit may be a PLL/VCO, and the fourth frequency conversion unit may be a Div/Dly. Accordingly, the signal synchronization module includes the third synchronization unit and the fourth synchronization unit. The third frequency conversion unit may be built in the third synchronization unit, or the third frequency conversion unit and the third synchronization unit are connected in communication. Similarly, the fourth frequency conversion unit may be built in the fourth synchronization unit, or the fourth frequency conversion unit and the fourth synchronization unit are connected in communication.

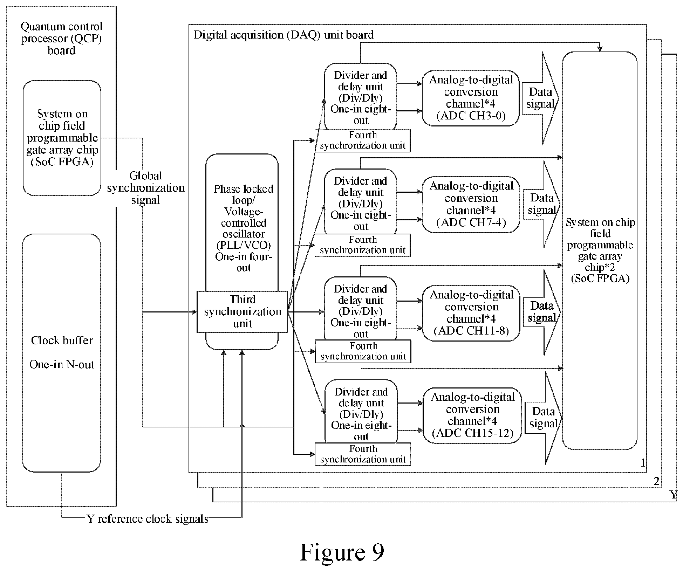

Hereinafter it is taken as an example that the third frequency conversion unit is a PLL/VCO and the fourth frequency conversion unit is a Div/Dly. In order to facilitate illustration, reference is made to Figure 9, which is a schematic structural diagram of another system for clock synchronization-based DAQ according to an embodiment of the present disclosure. As shown in Figure 9, it is assumed that there are Y DAQs, each of which corresponds to a REFCLK. Namely, there are Y REFCLKs in total. Y is an integer greater than or equal to 1 and less than N. The PLL/VCO performs frequency conversion on the received REFCLK to obtain the third-frequency clock sub-signal, and generates the third synchronization instruction according to the received Sync_GLB. Then, the PLL/VCO transmits the third synchronization instruction and the third-frequency clock sub-signal to the third synchronization unit. The third synchronization unit performs signal synchronization on the third-frequency clock sub-signal via a DFF, in response to the third synchronization instruction and based on the Sync_GLB, so as to output the third synchronized clock sub-signal.

Optionally, the third synchronization unit transmits the third synchronized clock sub-signal to the Div/Dly. The Div/Dly performs frequency conversion on and delay the received third synchronized clock sub-signal, to obtain the fourth-frequency clock sub-signal. The Div/Dly generates the fourth synchronization instruction according to the received Sync_GLB. Then, the Div/Dly transmits the fourth synchronization instruction and the fourth-frequency clock sub-signal to the fourth synchronization unit. The fourth synchronization unit performs the signal synchronization on the fourth-frequency clock sub-signal via a DFF, in response to the fourth synchronization instruction and based on the Sync_GLB, so as to output the fourth synchronized clock sub-signal.

Finally, the fourth synchronization unit optionally transmits the fourth synchronized clock sub-signal to the ADC channel. The fourth synchronized clock sub-signal is preferably an analog signal. Each Div/Dly as shown in Figure 9 corresponds to 4 ADC channels, and each ADC channel has two inputs. Preferably, the ADC channel converts the fourth synchronized clock sub-signal into a digital signal.

An input of the DFF corresponding to the PLL/VCO is the Sync_GLB, and the target clock signal corresponding to the PLL/VCO is a clock signal outputted from the VCO. For the Div/Dly, the target clock signal is a clock signal inputted into the Div/Dly. A new synchronization signal is generated via one or more stages of DFFs, for synchronizing outputs of frequency dividers in the system.

In this embodiment, the configurable fourth frequency conversion unit, namely, the Div/Dly is added to an input end of each ADC channel in the system for clock synchronization. Thereby, a phase of a signal outputted from each ADC channel is independent and tunable, reducing an inter-channel phase skew due to differences in wirings and components of a PCB.

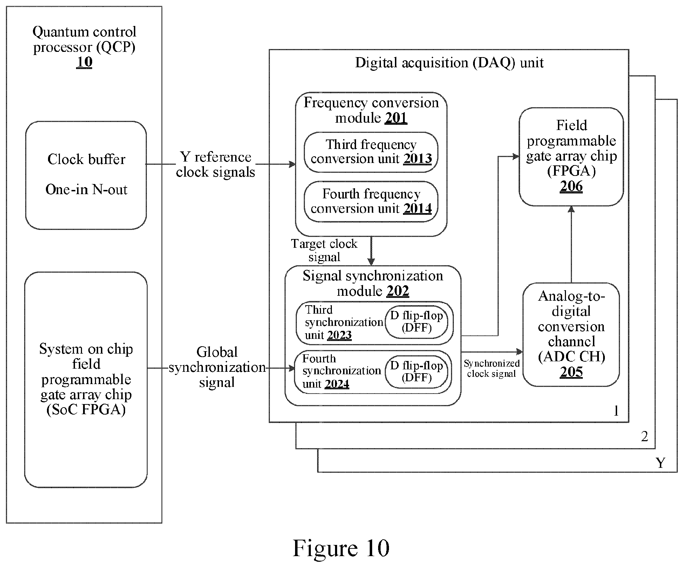

Reference is made to Figure 10 on a basis of Figure 3. Figure 10 is a schematic structural diagram of another DAQ based on a system for clock synchronization according to an embodiment of the present disclosure. Another embodiment of the present disclosure is provided by combining Figure 3 and Figure 10. The DAQ further includes an FPGA chip 206.

The fourth synchronization unit 2024 is optionally configured to transmit the fourth synchronized clock sub-signal to the FPGA chip 206.

The FPGA chip 206 is configured to receive a data signal transmitted by the ADC channel 205, under control of the fourth synchronized clock sub-signal.

In this embodiment, the DAQ in the digital-analog inter-converters is taken as an example. The DAQ includes the third frequency conversion unit and the fourth frequency conversion unit. In one embodiment, the third frequency conversion unit may be a PLL/VCO, and the fourth frequency conversion unit may be a Div/Dly. Accordingly, the signal synchronization module includes the third synchronization unit and the fourth synchronization unit. The third frequency conversion unit may be built in the third synchronization unit, or the third frequency conversion unit and the third synchronization unit are connected in communication. Similarly, the fourth frequency conversion unit may be built in the fourth synchronization unit, or the fourth frequency conversion unit and the fourth synchronization unit are connected in communication.

In view of the above, hereinafter it is taken as an example that the third frequency conversion unit is a PLL/VCO and the fourth frequency conversion unit is a Div/Dly. In order to facilitate illustration, reference is further made to Figure 9, which is a schematic structural diagram of another DAQ based on a system for clock synchronization according to an embodiment of the present disclosure. As shown in Figure 9, the fourth synchronization unit may further transmit the fourth synchronized clock sub-signal, of which a frequency has been concerted, to the FPGA chip. The FPGA chip determines, based on the fourth synchronized clock sub-signal, that clock synchronization has been achieved, and hence receives the data signal transmitted by the ADC channel.

In this embodiment, the Div/Dly in the system for clock synchronization has a function of frequency conversion. Hence, a signal of which the frequency has been converted may be further transmitted to the FPGA chip without arranging an additional device for frequency conversion, enhancing a degree of integration.

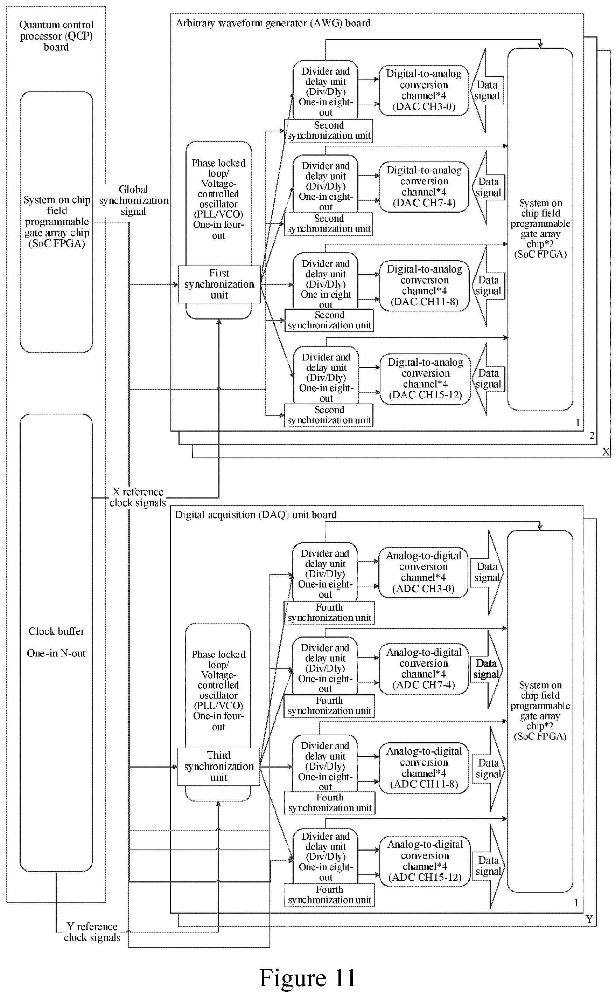

Reference is made to Figure 11 on a basis of the above embodiments. Figure 11 is a schematic structural diagram of another system for clock synchronization according to an embodiment of the present disclosure. As shown in Figure 11, a QCP transmits a reference clock signal to a PLL/VCO, so as to generate a clock signal of a new frequency. Then, the Div/Dly performs frequency division and delay regulation on the clock signal of the new frequency. Afterwards, such clock signal is inputted into a DAC channel, an ADC channel, and FPGA chips. The QCP distributes a signal for global synchronization to the PLL/VCO and the Div/Dly in the AWG, and to the PLL/VCO and the Div/Dly in the DAQ, so as to drive corresponding signal synchronization modules.

In the system for clock synchronization shown in Figure 11, an operation manner of each part and a direction of signal transmission are as illustrated in the foregoing embodiments, and therefore details are not described again herein.

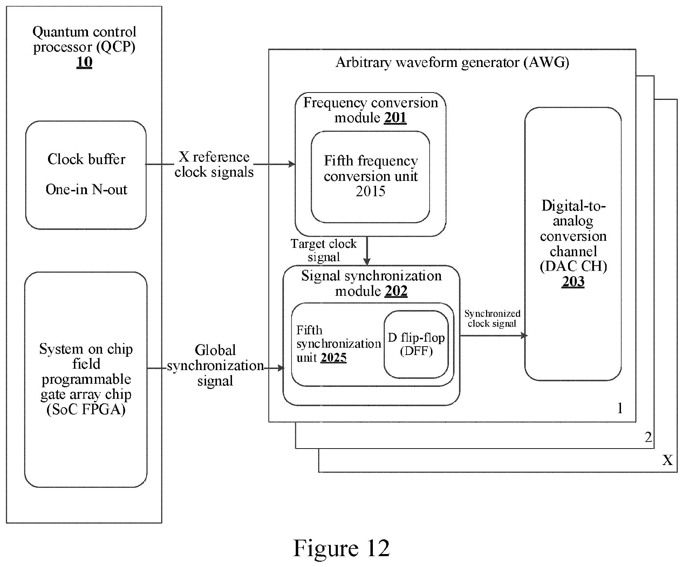

Reference is made to Figure 12 on a basis of Figure 3. Figure 12 is a schematic structural diagram of another AWG based on a system for clock synchronization-based AWG according to an embodiment of the present disclosure. Another embodiment of the present disclosure is provided by combining Figure 3 and Figure 12. The N digital-analog inter-converters 20 include an AWG. The AWG is one of the digital-analog inter-converters 20, and includes a DAC channel 203. The frequency conversion module 201 includes a fifth frequency conversion unit 2015, the signal synchronization module 202 includes a fifth synchronization unit 2025, and the fifth synchronization unit 2025 includes at least one DFF.

The fifth frequency conversion unit 2015 is configured to perform frequency conversion and phase-locked loop processing on the received reference clock signal to obtain a fifth-frequency clock sub-signal, and generate a fifth synchronization instruction according to the received global synchronization signal. The target clock signal includes the fifth-frequency clock sub-signal. The instruction for signal synchronization includes the fifth synchronization instruction.

The fifth frequency conversion unit 2015 is further configured to transmit the fifth synchronization instruction and the fifth-frequency clock sub-signal to the fifth synchronization unit 2025.

The fifth synchronization unit 2025 is configured to perform signal synchronization on the fifth-frequency clock sub-signal via the at least one DFF in the fifth synchronization unit 2025, in response to the fifth synchronization instruction and based on the signal for global synchronization, to obtain a fifth synchronized clock sub-signal. The synchronized clock signal includes the fifth synchronized clock sub-signal.

The fifth synchronization unit 2025 is optionally configured to transmit the fifth synchronized clock sub-signal to the DAC channel 203. The fifth synchronized clock sub-signal is preferably a digital signal.

The DAC channel 203 is preferably configured to convert the fifth synchronized clock sub-signal into an analog signal.

In this embodiment, the AWG in the digital-analog inter-converters is taken as an example. The AWG includes the fifth synchronization unit. In one embodiment, the fifth synchronization unit may be a PLL/VCO. Accordingly, the signal synchronization module includes the fifth synchronization unit. The fifth frequency conversion unit may be built in the fifth synchronization unit, or the fifth frequency conversion unit and the fifth synchronization unit are connected in communication.

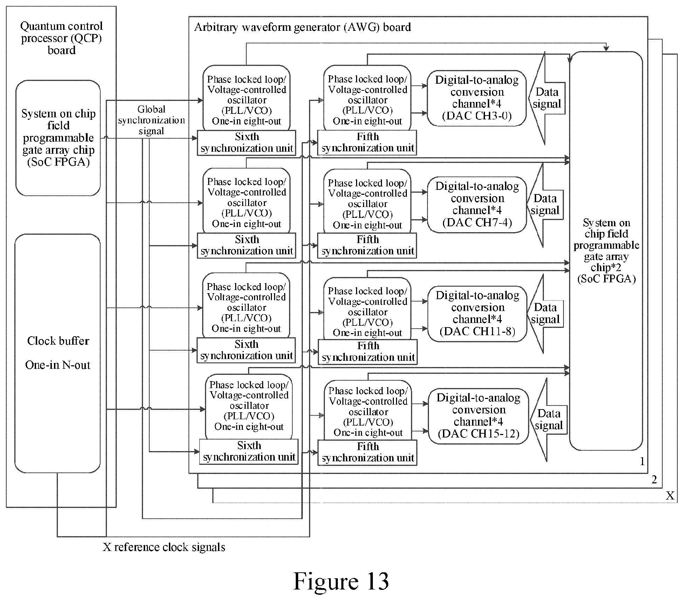

Hereinafter it is taken as an example that the fifth frequency conversion unit is a PLL/VCO. In order to facilitate understanding, reference is made to Figure 13, which is a schematic structural diagram of another AWG based on a system for clock synchronization according to an embodiment of the present disclosure. As shown in Figure 13, it is assumed that there are X AWGs, and each AWG corresponds to a REFCLK. Namely, there are X REFCLKs in total. X is an integer greater than or equal to 1 and less than N. The PLL/VCO performs frequency conversion on the received REFCLK to obtain the fifth-frequency clock sub-signal, and generates the fifth synchronization instruction according to the received Sync_GLB. Then, the PLL/VCO transmits the fifth synchronization instruction and the fifth-frequency clock sub-signal to the fifth synchronization unit. The fifth synchronization unit performs signal synchronization on the fifth-frequency clock sub-signal via a DFF, in response to the fifth synchronization instruction and based on the Sync_GLB, so as to output the fifth synchronized clock sub-signal.

Optionally, the fifth synchronization unit transmits the fifth synchronized clock sub-signal to the DAC channel. The fifth synchronized clock sub-signal is preferably a digital signal. Each fifth synchronization unit as shown in Figure 13 corresponds to 4 DAC channels, and each DAC channel has two inputs. Preferably, the DAC channel converts the fifth synchronized clock sub-signal into an analog signal.

An input of the DFF corresponding to the PLL/VCO is the Sync_GLB, and the target clock signal corresponding to the PLL/VCO is a clock signal outputted from the VCO.

In this embodiment, multiple PLLs/VCOs are added to an input end of each DAC channel in the system for clock synchronization, so as to implement frequency division. Thereby, a frequency of a signal can be tuned, providing a feasible implementation for clock synchronization.

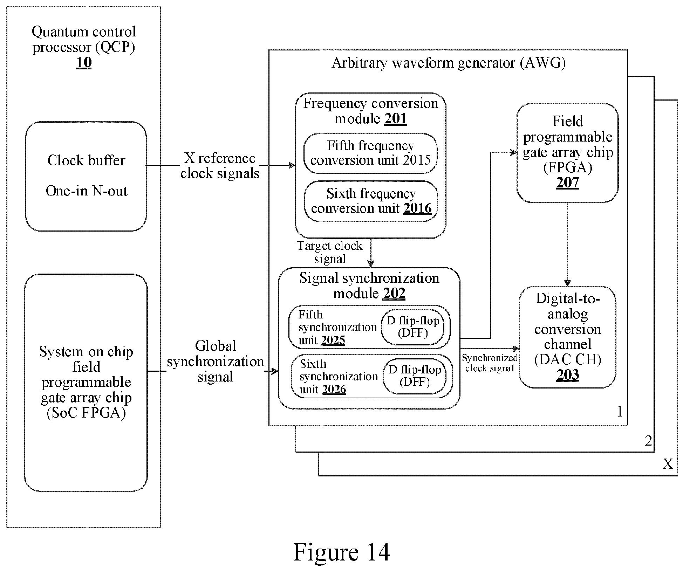

Reference is made to Figure 14 on a basis of Figure 3. Figure 14 is a schematic structural diagram of another AWG based on a system for clock synchronization according to an embodiment of the present disclosure. Another embodiment of the present disclosure is provided by combining Figure 3 and Figure 14. The AWG further includes an FPGA chip 207. The frequency conversion module 201 further includes a sixth frequency conversion unit 2016, the signal synchronization module 202 further includes a sixth synchronization unit 2026, and the sixth synchronization unit 2026 includes at least one DFF.

The sixth frequency conversion unit 2016 is configured to perform frequency conversion and phase-locked loop processing on the received reference clock signal to obtain a sixth-frequency clock sub-signal, and generate a sixth synchronization instruction according to the received global synchronization signal. The target clock signal includes the sixth-frequency clock sub-signal, and the instruction for signal synchronization includes the sixth synchronization instruction is included.

The sixth frequency conversion unit 2016 is further configured to transmit the sixth synchronization instruction and the sixth-frequency clock sub-signal to the sixth synchronization unit 2026.

The sixth synchronization unit 2026 is configured to perform signal synchronization on the sixth-frequency clock sub-signal via the at least one DFF in the sixth synchronization unit 2016, in response to the sixth synchronization instruction and based on the signal for global synchronization, to obtain a sixth synchronized clock sub-signal. The synchronized clock signal includes the sixth synchronized clock sub-signal.

The sixth synchronization unit 2026 is optionally configured to transmit the sixth synchronized clock sub-signal to the FPGA chip 207.

The FPGA chip 207 is configured to transmit a data signal to the DAC channel 203, under control of the sixth synchronized clock sub-signal.

In this embodiment, the AWG in the digital-analog inter-converters is taken as an example. The AWG includes the fifth synchronization unit and the sixth synchronization unit. In one embodiment, both the fifth synchronization unit and the sixth synchronization unit may be a PLL/VCO. Accordingly, the signal synchronization module includes the fifth synchronization unit and the sixth synchronization unit. The fifth frequency conversion unit may be built in the fifth synchronization unit, or the fifth frequency conversion unit and the fifth synchronization unit are connected in communication. Similarly, the sixth frequency conversion unit may be built in the sixth synchronization unit, or the sixth frequency conversion unit and the sixth synchronization unit are connected in communication.

Hereinafter it is taken as an example that each of the fifth frequency conversion unit and the sixth frequency conversion unit are a PLL/VCO. In order to facilitate illustration, reference is further made to Figure 13, which is a schematic structural diagram of another AWG based on a system for clock synchronization according to an embodiment of the present disclosure. As shown in Figure 13, it is assumed that there are X AWGs, and each AWG corresponds to a REFCLK. Namely, there are X REFCLKs in total. X is an integer greater than or equal to 1 and less than N. It is appreciated from the foregoing embodiments that the PLL/VCO corresponding to the fifth synchronization unit performs frequency conversion on the received REFCLK to obtain the fifth-frequency clock sub-signal, and generates the fifth synchronization instruction according to the received Sync_GLB. Then, the PLL/VCO corresponding to the fifth synchronization unit transmits the fifth synchronization instruction and the fifth-frequency clock sub-signal to the fifth synchronization unit. The fifth synchronization unit performs signal synchronization on the fifth-frequency clock sub-signal via a DFF, in response to the fifth synchronization instruction and based on the Sync_GLB, so as to output the fifth synchronized clock sub-signal.

Similarly, the PLL/VCO corresponding to the sixth synchronization unit performs frequency conversion on the received REFCLK to obtain the sixth-frequency clock sub-signal, and generates the sixth synchronization instruction according to the received Sync_GLB. Then, the PLL/VCO corresponding to the sixth synchronization unit transmits the sixth synchronization instruction and the sixth-frequency clock sub-signal to the sixth synchronization unit. The sixth synchronization unit performs signal synchronization on the sixth-frequency clock sub-signal via a DFF, in response to the sixth synchronization instruction and based on the Sync_GLB, so as to output the sixth synchronized clock sub-signal.

The fifth synchronized clock sub-signal and the sixth synchronized clock sub-signal have different frequencies. Optionally, the fifth synchronization unit transmits the fifth synchronized clock sub-signal to the DAC channel. The fifth synchronized clock sub-signal is preferably a digital signal. The sixth synchronization unit transmits the sixth synchronized clock sub-signal to the FPGA chip. The FPGA chip determines, based on the sixth synchronized clock sub-signal, that clock synchronization has been achieved, and accordingly transmits a data signal to the DAC channel.

In this embodiment, multiple PLLs/VCOs are configured to implement frequency conversion in the system for clock synchronization. A signal of which a frequency has been converted may be transmitted to the FPGA chip, so as to improve the feasibility and operability of the scheme.

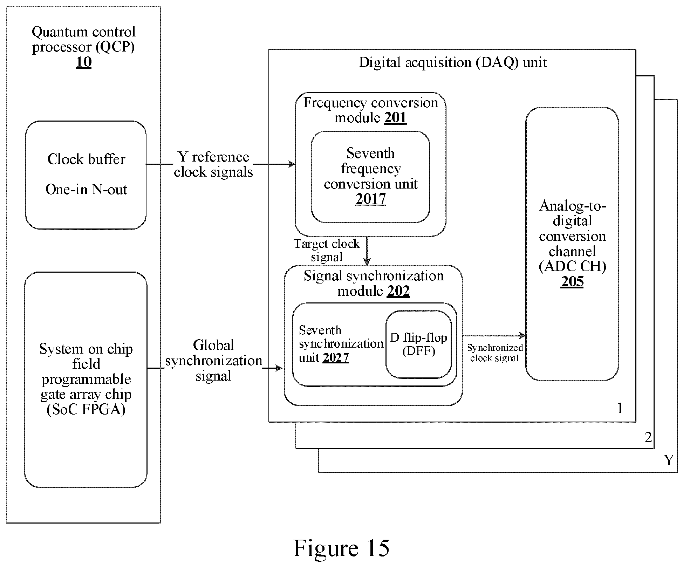

Reference is made to Figure 15 on a basis of Figure 3. Figure 15 is a schematic structural diagram of another DAQ based on a system for clock synchronization according to an embodiment of the present disclosure. Another embodiment of the present disclosure is provided by combining Figure 3 and Figure 15. The N digital-analog inter-converters 20 include a DAQ. The DAQ is one of the digital-analog inter-converters 20, and includes an ADC channel 205. The frequency conversion module 201 includes a seventh frequency conversion unit 2017, the signal synchronization module 202 includes a seventh synchronization unit 2027, and the seventh synchronization unit 2027 includes at least one DFF.

The seventh frequency conversion unit 2017 is configured to perform frequency conversion and phase-locked loop processing on the received reference clock signal to obtain a seventh-frequency clock sub-signal, and generate a seventh synchronization instruction according to the received global synchronization signal. The target clock signal includes the seventh-frequency clock sub-signal, and the instruction for signal synchronization includes the seventh synchronization instruction.

The seventh frequency conversion unit 2017 is further configured to transmit the seventh synchronization instruction and the seventh-frequency clock sub-signal to the seventh synchronization unit 2027.

The seventh synchronization unit 2027 is configured to perform signal synchronization on the seventh-frequency clock sub-signal via the at least one DFF in the seventh synchronization unit 2027, in response to the seventh synchronization instruction and based on the signal for global synchronization, to obtain a seventh synchronized clock sub-signal. The synchronized clock signal includes the seventh synchronized clock sub-signal.

The seventh synchronization unit 2027 is optionally configured to transmit the seventh synchronized clock sub-signal to the ADC channel 205. The seventh synchronized clock sub-signal is preferably an analog signal.

The ADC channel 205 is preferably configured to convert the seventh synchronized clock sub-signal into a digital signal.

In this embodiment, the DAQ in the digital-analog inter-converters is taken as an example. The DAQ includes a seventh synchronization unit. In one embodiment, the seventh synchronization unit may be a PLL/VCO. Accordingly, the signal synchronization module includes the seventh synchronization unit. The seventh frequency conversion unit may be built in the seventh synchronization unit, or the seventh frequency conversion unit and the seventh synchronization unit are connected in communication.

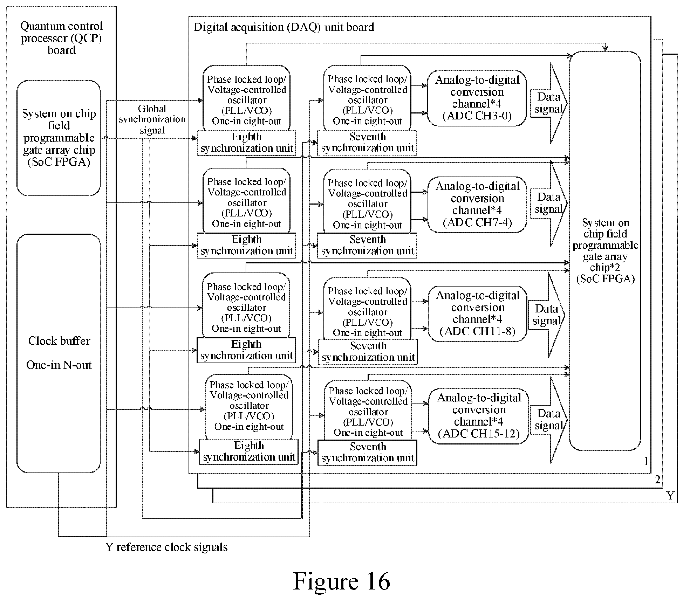

Hereinafter it is taken as example that the seventh frequency conversion unit is a PLL/VCO. In order to facilitate illustration, reference is made to Figure 16, which is a schematic structural diagram of another DAQ based on a system for clock synchronization according to an embodiment of the present disclosure. As shown in Figure 16, it is assumed that there are Y DAQs, and each DAQ corresponds to a REFCLK. Namely, there are Y REFCLKs in total. Y is an integer greater than or equal to 1 and less than N. The PLL/VCO performs frequency conversion on the received REFCLK to obtain the seventh-frequency clock sub-signal, and generates the seventh synchronization instruction according to the received Sync_GLB. Then, the PLL/VCO transmits the seventh synchronization instruction and the seventh-frequency clock sub-signal to the seventh synchronization unit. The seventh synchronization unit performs signal synchronization on the seventh-frequency clock sub-signal via a DFF, in response to the seventh synchronization instruction and based on the Sync_GLB, so as to output the seventh synchronized clock sub-signal.

Optionally, the seventh synchronization unit transmits the seventh synchronized clock sub-signal to the ADC channel. The seventh synchronized clock sub-signal is preferably an analog signal. Each seventh synchronization unit as shown in Figure 16 corresponds to 4 ADC channels, and each ADC channel has two inputs. Preferably, the ADC channel converts the seventh synchronized clock sub-signal into a digital signal.

An input of the DFF corresponding to the PLL/VCO is the Sync_GLB, and the target clock signal corresponding to the PLL/VCO is a clock signal outputted from the VCO.

In this embodiment, multiple PLLs/VCOs are added to an input end of each ADC channel in the system for clock synchronization, for implementing frequency division. Thereby, a signal frequency is tuned, providing a feasible implementation for clock synchronization.

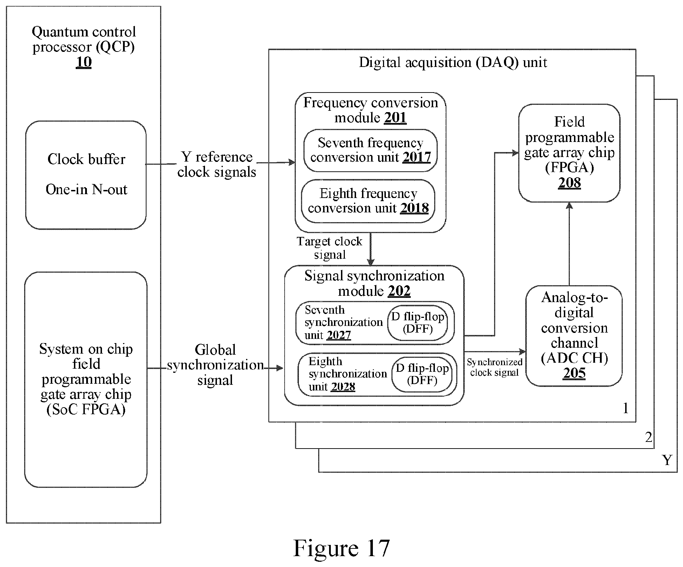

Reference is made to Figure 17 on a basis of Figure 3. Figure 17 is a schematic structural diagram of another DAQ based on a system for clock synchronization according to an embodiment of the present disclosure. Another embodiment of the present disclosure is provided by combining Figure 3 and Figure 17. The DAQ further includes an FPGA chip 208. The frequency conversion module 201 includes an eighth frequency conversion unit 2018, the signal synchronization module 202 includes an eighth synchronization unit 2028, and the eighth synchronization unit 2028 includes at least one DFF.

The eighth frequency conversion unit 2018 is configured to perform frequency conversion and phase-locked loop processing on the received reference clock signal, to obtain an eighth-frequency clock sub-signal and generate an eighth synchronization instruction according to the received global synchronization signal. The target clock signal includes the eighth-frequency clock sub-signal, and the instruction for signal synchronization includes the eighth synchronization instruction.

The eighth frequency conversion unit 2018 is further configured to transmit the eighth synchronization instruction and the eighth-frequency clock sub-signal to the eighth synchronization unit 2028.

The eighth synchronization unit 2028 is configured to perform signal synchronization on the eighth-frequency clock sub-signal via the at least one DFF in the eighth synchronization unit 2028, in response to the eighth synchronization instruction and based on the signal for global synchronization, to obtain an eighth synchronized clock sub-signal. The synchronized clock signal includes the eighth synchronized clock sub-signal.

The eighth synchronization unit 2028 is optionally configured to transmit the eighth synchronized clock sub-signal to the FPGA chip 208.

The FPGA chip 208 is configured to receive a data signal transmitted by the ADC channel 205, under control of the eighth synchronized clock sub-signal.

In this embodiment, the DAQ in the digital-analog inter-converters is taken as an example. The DAQ includes the seventh synchronization unit and the eighth synchronization unit. In one embodiment, each of the seventh synchronization unit and the eighth synchronization unit may be a PLL/VCO. Accordingly, the signal synchronization module includes the seventh synchronization unit and the eighth synchronization unit. The seventh frequency conversion unit may be built in the seventh synchronization unit, or the seventh frequency conversion unit and the seventh synchronization unit are connected in communication. Similarly, the eighth frequency conversion unit may be built in the eighth synchronization unit, or the eighth frequency conversion unit and the eighth synchronization unit are connected in communication.

Hereinafter it is taken as an example that each of the seventh frequency conversion unit and the eighth frequency conversion unit is a PLL/VCO. In order to facilitate illustration, reference is further made to Figure 16, which is a schematic structural diagram of another DAQ based on a system for clock synchronization-based according to an embodiment of the present disclosure. As shown in Figure 16, it is assumed that there are Y DAQs, and each DAQ corresponds to a REFCLK. Namely, there are Y REFCLKs in total. Y is an integer greater than or equal to 1 and less than N. It is appreciated from the foregoing embodiments that the PLL/VCO corresponding to the seventh synchronization unit performs frequency conversion on the received REFCLK to obtain the seventh-frequency clock sub-signal, and generates the seventh synchronization instruction according to the received Sync_GLB. Then, the PLL/VCO corresponding to the seventh synchronization unit transmits the seventh synchronization instruction and the seventh-frequency clock sub-signal to the seventh synchronization unit. The seventh synchronization unit performs signal synchronization on the seventh-frequency clock sub-signal via a DFF, in response to the seventh synchronization instruction and based on the Sync_GLB, so as to output the seventh synchronized clock sub-signal.

Similarly, the PLL/VCO corresponding to the eighth synchronization unit performs frequency conversion on the received REFCLK to obtain the eighth-frequency clock sub-signal, and generates the eighth synchronization instruction according to the received Sync_GLB. Then, the PLL/VCO corresponding to the eighth synchronization unit then transmits the eighth synchronization instruction and the eighth-frequency clock sub-signal to the eighth synchronization unit. The eighth synchronization unit performs signal synchronization on the eighth-frequency clock sub-signal via a DFF, in response to the eighth synchronization instruction and based on the Sync_GLB, so as to output the eighth synchronized clock sub-signal.

The seventh synchronized clock sub-signal and the eighth synchronized clock sub-signal have different frequencies. Optionally, the seventh synchronization unit transmits the seventh synchronized clock sub-signal to the ADC channel. The seventh synchronized clock sub-signal is preferably an analog signal. Preferably, the eighth synchronization unit transmits the eighth synchronized clock sub-signal to the FPGA chip. The FPGA chip determines, based on the eighth synchronized clock sub-signal, that clock synchronization has been achieved, and accordingly receives a data signal transmitted by the ADC channel.

In this embodiment, multiple PLLs/VCOs are used to implement frequency conversion in the system for clock synchronization is provided. A signal of which the frequency has been converted may be further transmitted to the FPGA chip, improving feasibility and operability of the scheme.

Another embodiment of the present disclosure is provided on a basis of the one corresponding to Figure 3. The system for clock synchronization further includes a chassis. The N digital-analog inter-converters 20 include P pairs of AWGs and Q pairs of DAQs. Each pair of AWGs includes two AWGs, each pair of DAQs includes two DAQs, and Q and P are both integers greater than or equal to 1.

The QCP 10, the P pairs of AWGs, and the Q pairs of DAQs are all disposed inside the chassis.

Each pair of AWGs is symmetrically disposed with respect to the QCP 10.

Each pair of DAQs is symmetrically disposed with respect to the QCP 10.

In this embodiment, components in the system for clock synchronization may be integrated in the chassis. Namely, the provided quantum control-and-measurement system is simplified and convenient for usage, while having a function of the clock synchronization. Hence, a quantum scientist is able to focus on qubits, rather than spending much time on constructing auxiliary experiment devices.

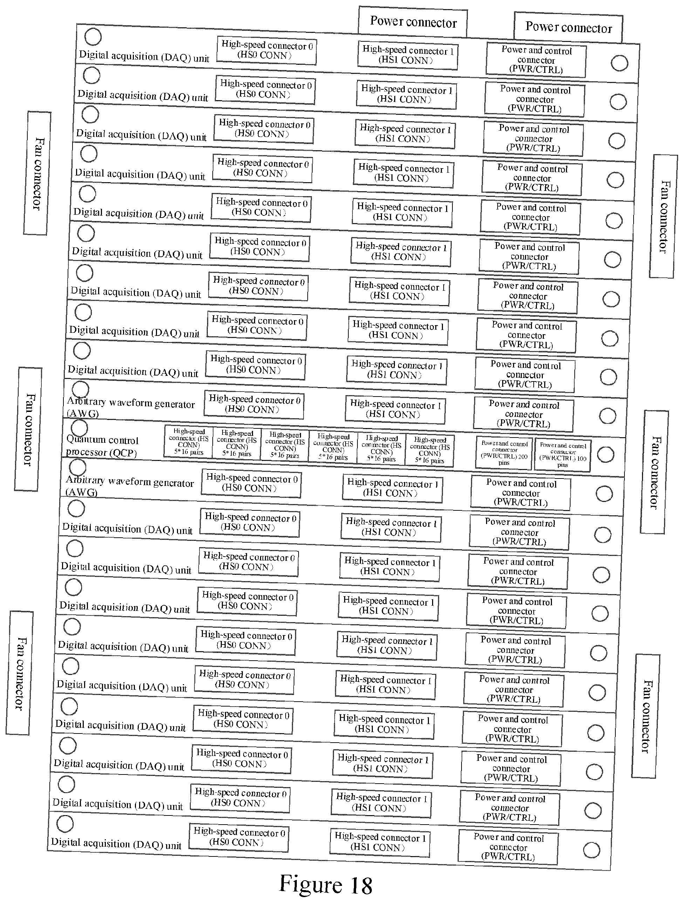

In order to facilitate understanding, reference is made to Figure 18, which is a schematic structural diagram of a chassis based on a system for clock synchronization according to an embodiment of the present disclosure. As shown in Figure 18, the chassis is similar to a standard chassis in a standard ATCA, and customized to meet a requirement of the system. A QCP is disposed at a middle position inside the chassis, and the QCP has a high-speed connector (HS CONN) and a power and control connector (PWR/CTRL). Both the AWGs and the DAQs may be of an even number, namely, there are P pairs of AWGs and Q pairs of DAQs. In such case, each pair of AWGs is disposed at two sides of the QCP and symmetrically with respect to the QCP. Similarly, each pair of DAQs is disposed at two sides of the QCP and symmetrically with respect to the QCP.

Figure 18 is taken as an example, where P is equal to 9 and Q is equal to 1. Namely, there are 18 AWGs and 2 DAQs. It is assumed that each AWG has 16 DAC channels and each DAQ has 16 ADC channels. Thus, there are 320 channels in total. In addition, an auxiliary power supply and fans are disposed inside the chassis, of which details are not described herein.

In this embodiment, the QCP is disposed at a middle position in the system for clock synchronization. On such basis, clock signals outputted from the QCP to each AWG and each DAQ is subject to equal delay, and hence system deployment would be more reasonable. When P is equal to 9 and Q is equal to 1, 320 channels of ADC and DAC can be supported, and three dimensions of the whole chassis are approximately 700 *370*600 (in millimeters). Therefore, the system has a high degree of integration. It is not necessary to establish complex inter-system cable connection before an experiment, and the synchronization is implemented with simple operations. Moreover, a cost is reduced.

Another embodiment of the present disclosure is provided on a basis of the embodiment corresponding to Figure 3. The system for clock synchronization further includes a chassis. The N digital-analog inter-converters 20 include K AWGs and (N-K) DAQs, where K is an integer greater than or equal to 1 and less than N;

The QCP 10, the K AWGs, and the (N-K) DAQs are all disposed inside the chassis;

The K AWGs are disposed at a side of the QCP 10. Alternatively, the K AWGs are disposed at two sides of the QCP 10.

The (N-K) DAQs are disposed at a side of the QCP 10. Alternatively, the (N-K) DAQs are disposed at two sides of the QCP 10.

In this embodiment, components in the system for clock synchronization may be integrated in the chassis. Namely, the provided quantum control-and-measurement system is simplified and convenient for usage, while having a function of the clock synchronization. Hence, a quantum scientist is able to focus on qubits, rather than spending much time on constructing auxiliary experiment devices.

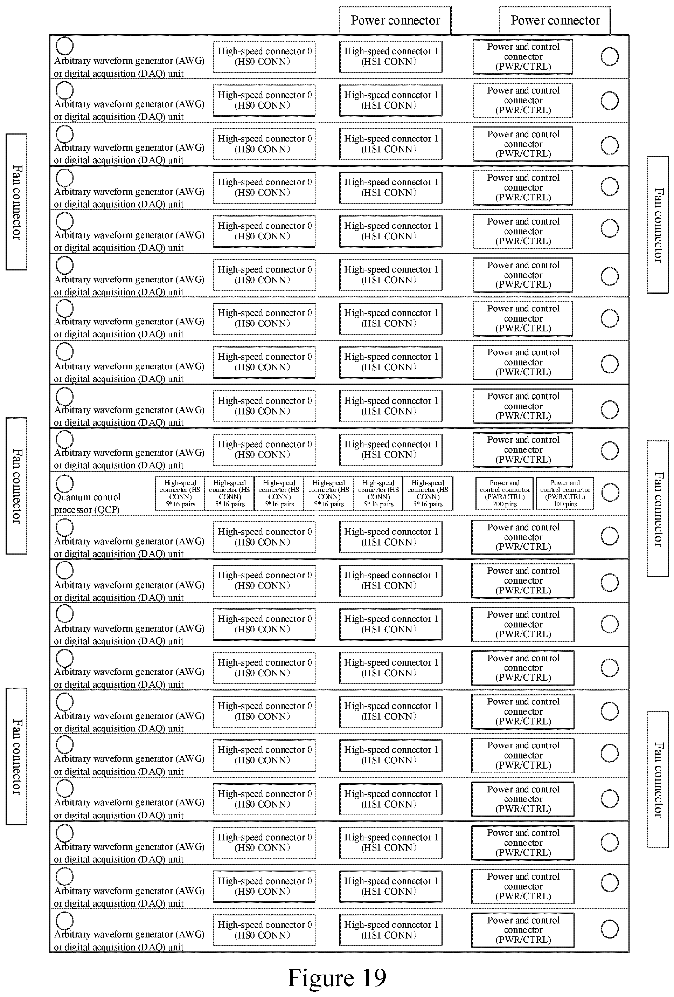

In order to facilitate understanding, reference is made to Figure 19, which is a schematic structural diagram of another chassis based on a system for clock synchronization according to an embodiment of the present disclosure. As shown in Figure 19, the chassis is similar to a standard chassis in a standard ATCA, and customized to meet a requirement of the system. A QCP is disposed at a middle position inside the chassis, and the QCP has an HS CONN and a PWR/CTRL.

It is assumed that one or both of the AWGs or the DAQs are of an odd number. In such case, there are K AWGs and (N-K) DAQs. The AWGs and the DAQs are disposed at two sides of the QCP in an arbitrary manner. Figure 19 is taken as an example, wherein N is equal to 20. It is assumed that each AWG has 16 DAC channels and each DAQ has 16 ADC channels. In such case, there are 320 channels in total. In addition, an auxiliary power supply and fans are disposed inside the chassis, of which details are not described herein.

In this embodiment, the QCP, the AWGs, and the DAQs are disposed in the chassis in the system for clock synchronization is provided. Positions of the components in the chassis may be flexibly adjusted, and thereby diversity and flexibility of component deployment is improved.

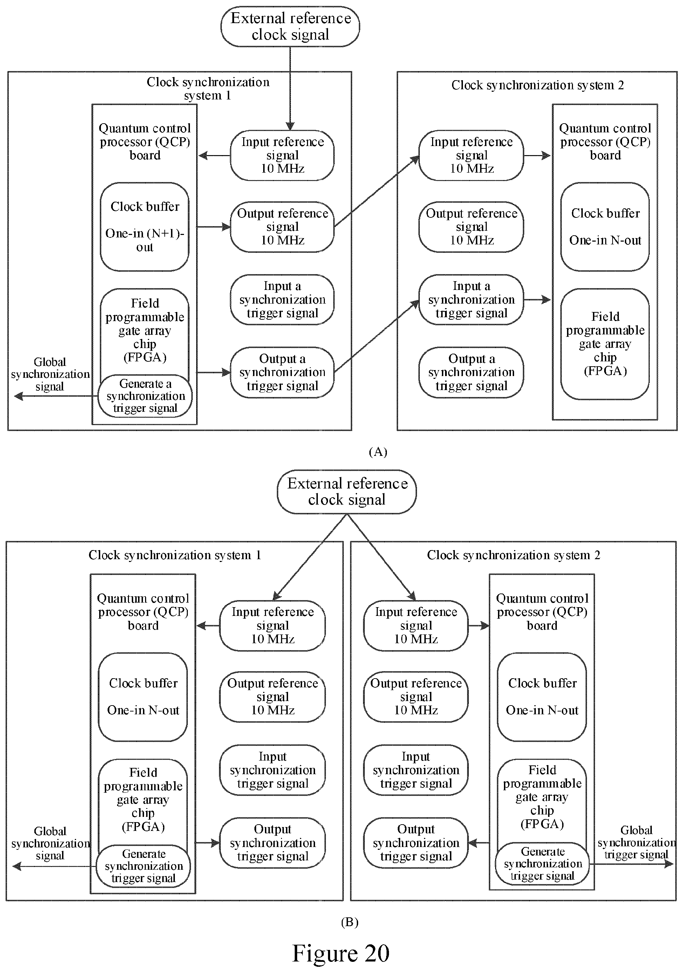

Reference is made to Figure 20 on a basis of the foregoing embodiments. Figure 20 is a schematic structural diagram of multiple cascading systems for clock synchronizations according to an embodiment of the present disclosure. A cascading manner is as shown in subfigure (A) of Figure 20. A system 1 for clock synchronization obtains an external reference clock signal, and a QCP of the system 1 generates synchronization trigger signals via an FPGA chip. A synchronization trigger signal serves as the Sync_GLB for the system 1. Another synchronization trigger signal is transmitted to a system 2 for clock synchronization via a cable, in order to trigger the Sync_GLB for the system 2.

Another cascading manner is as shown in the subfigure (B) of Figure 20. A system for clock synchronization 1 and a system for clock synchronization 2 obtain a same external reference clock signal, respectively. The QCP of the system 1 clock generates a synchronization trigger signal via a FPGA chip, as the Sync_GLB for the system 1. The QCP of the system 2 generates a synchronization trigger signal via a FPGA chip, as the Sync_GLB for the system 2.

Another embodiment of the present disclosure is provided on a basis of Figure 3. The N digital-analog inter-converters 20 include an AWG and a DAQ. The AWG includes a DAC channel 203, and the DAQ includes an ADC channel 205.

The QCP 10 is further configured to load a code file for an FPGA chip. The code file includes a first register parameter, a second register parameter, a third register parameter, and a fourth register parameter.

The AWG is configured to write the first register parameter into a frequency conversion module 201 which the AWG includes.

The DAQ is configured to write the second register parameter into a frequency conversion module 201 which the DAQ includes.

The AWG is further configured to write the third register parameter into the DAC channel 203 which the AWG includes.

The DAQ is further configured to write the fourth register parameter into the ADC channel 205 which the DAQ includes.

In this embodiment, the N digital-analog inter-converters in the system for clock synchronization include at least one AWG and at least one DAQ. Each AWG include the DAC channel, a PLL/VCO, and a Div/Dly. Each DAQ includes the ADC channel, a PLL/VCO, and a Div/Dly. Before clock synchronization, these modules need to be initialized based on the code file for a FPGA chip.

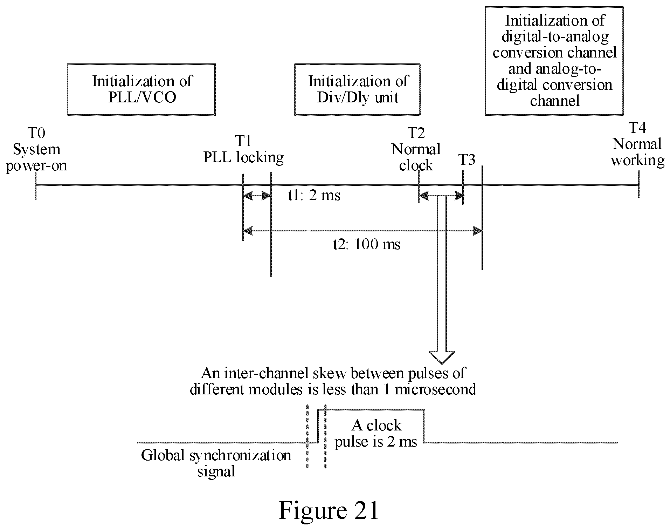

Reference is made to Figure 21, which is a schematic timeline of signal synchronization according to an embodiment of the present disclosure. As shown in Figure 21, the system for clock synchronization is powered at moment T0, and a normal operating mode is entered when the code file for FPGA chip(s) has been loaded. The AWG writes the first register parameter into the corresponding PLL/VCO, and the DAQ writes the second register parameter into the corresponding PLL/VCO. At moment T1, the FPGA chip(s) receives a lock-indicating signal of the code file, waits for approximate 2 ms, and completes writing register parameters of the Div/Dly. That is, the AWG writes the first register parameter into the Div/Dly, and the DAQ writes the second register parameter into the Div/Dly.

An output of a clock signal is normal at moment T2. At such time, the FPGA chip of the QCP initiates the signal for global synchronization. Duration of the Sync_GLB reaching each module is not strictly required to be identical, as long as a skew being within 1 microsecond. At moment T3, the synchronization is completed. At such time, an FPGA chip of the AWG writes the third register parameter into the DAC channel, and an FPGA chip of the DAQ writes the fourth register parameter into the ADC channel, such that channel configuration is achieved. At moment T4, the configuration is completed, and a working mode is entered. Receiving data by the ADC channel and/or transmitting data by the DAC channel may start.

The QCP is configured to load the code file for FPGA chip(s). The code file includes the first register parameter, the second register parameter, the third register parameter, and the fourth register parameter;
The AWG is configured to write the first register parameter into the frequency conversion module 201 which the AWG includes.

The DAQ is configured to write the second register parameter into the frequency conversion module 201 which the DAQ includes.

The AWG is further configured to write the third register parameter into the DAC channel 203 which the AWG includes.

The DAQ is further configured to write the fourth register parameter into the ADC channel 205 which the DAQ includes.

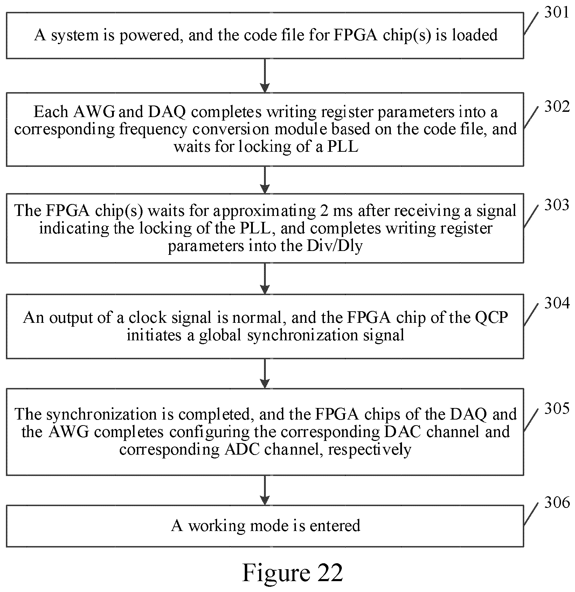

Hereinafter a flow of implementing signal synchronization is illustrated in conjunction with Figure 22. Reference is made to Figure 22, which is a schematic flowchart of implementing signal synchronization according to an embodiment of the present disclosure. As shown in Figure 12, the flow includes steps 301 to 306.

In step 301, the system for clock synchronization is powered at moment T0, and a normal operating mode is entered when the code file for FPGA chip(s) has been loaded. The code file includes a first register parameter, a second register parameter, a third register parameter, and a fourth register parameter.

In step 302, writing register parameters into the PLL/VCO(s) is completed based on the code file, and the AWG(s) and the DAQ(s) wait for locking of the PLL. Each AWG and DAQ completes writing register parameters into the corresponding frequency conversion module based on the code file, and waits for locking of the PLL.

In step 303, the FPGA chip(s) waits for approximating 2 ms after receiving a signal indicating the locking of the PLL, and completes writing register parameters into the Div/Dly.

In step 304, an output of a clock signal is normal at moment T2. At such time, the FPGA chip of the QCP initiates a signal for global synchronization.

In step 305, the synchronization is completed, and the FPGA chips of the DAQ and the AWG completes configuring the corresponding DAC channel and corresponding ADC channel, respectively.

In step 306, a working mode is entered.

In this embodiment, in order to complete an operation of synchronization, it is only required to trigger a synchronization pulse after the configuration in the system for clock synchronization. A quantity of channels integrated in the quantum control-and-measurement system can support qubit tests on a 56-bit Gmon, and a skew among different channels can be less than 15 picoseconds (ps). The AWG(s) outputs test data on waveform synchronization. In a case that delay calibration is not enabled, an inter-channel skew among different channels of the same module is within 100 ps, and an inter-channel skew among channels of different modules is within 200 ps. In a case that delay calibration is enabled, an inter-channel skew among different channels is within 15 ps. Test data on synchronization is inputted into the DAQ. When a sampling rate (or a conversion rate) is 1 gigabit samples per second (GSPS), different channels can be completely aligned with each other.

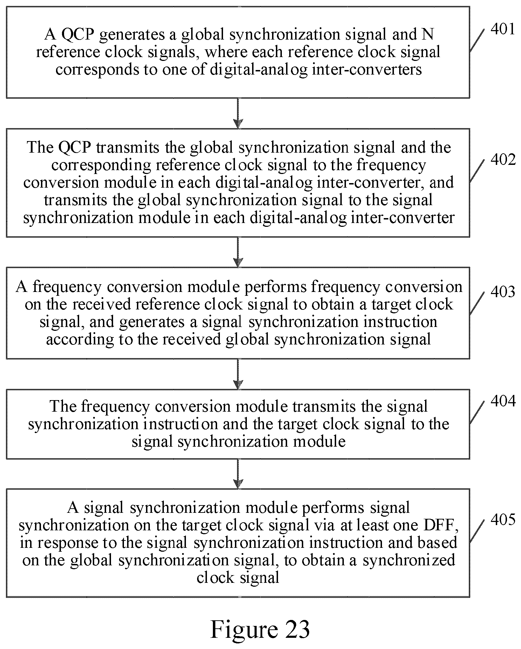

Hereinafter a method for controlling signal synchronization is described according to embodiments of the present disclosure. Reference is made to Figure 23, which is a schematic flowchart of a method for controlling signal synchronization according to an embodiment of the present disclosure. The method for controlling signal synchronization is applied to a system for clock synchronization. The system for clock synchronization includes a quantum control processor (QCP) and N digital-analog inter-converters, each digital-analog inter-converter includes a frequency conversion module and a signal synchronization module. The signal synchronization module includes at least one DFF. N is an integer greater than 1. The method for controlling signal synchronization includes steps 401 to 405.

In step 401, the QCP generates a signal for global synchronization and N reference clock signals. Each reference clock signal corresponds to one of the digital-analog inter-converters.

In this embodiment, the N digital-analog inter-converters include at least one arbitrary waveform generator (AWG) and at least one digital acquisition (DAQ) unit. The QCP includes a clock buffer and a field programmable gate array (FPGA) chip. A quantity of an input of the clock buffer is equal to 1, and a quantity of outputs of the clock buffer is equal to N. Namely, N reference clock signals may be outputted, such that each digital-analog inter-converter corresponds to one reference clock signal. The FPGA chip outputs the signal for global synchronization, and the N digital-analog inter-converters all uses the uniform global synchronization signal.

In step 402, the QCP transmits the signal for global synchronization and each reference clock signal to the frequency conversion module in the corresponding digital-analog inter-converter, and transmits the signal for global synchronization to the signal synchronization module in each digital-analog inter-converter.

In this embodiment, by using the QCP, the system for clock synchronization transmits the signal for global synchronization and each reference clock signal to the frequency conversion module in the corresponding digital-analog inter-converter, and transmits the signal for global synchronization to the signal synchronization module in each digital-analog inter-converter (i.e. the AWG and the DAQ).

In step 403, the frequency conversion module performs frequency conversion on the received reference clock signal to obtain a target clock signal, and generates an instruction for signal synchronization according to the received global synchronization signal.

In this embodiment, by using the frequency conversion module, the system for clock synchronization performs frequency conversion on the received reference clock signal to obtain the target clock signal, may further generate the instruction for signal synchronization according to the received global synchronization signal.

In step 404, the frequency conversion module transmits the instruction for signal synchronization and the target clock signal to the signal synchronization module.

In this embodiment, by using the frequency conversion module, the system for clock synchronization transmits the instruction for signal synchronization and the target clock signal to the signal synchronization module. The instruction for signal synchronization is used for triggering clock synchronization.

In step 405, the signal synchronization module performs signal synchronization on the target clock signal via the at least one DFF, in response to the instruction for signal synchronization and based on the signal for global synchronization, to obtain a synchronized clock signal.

In this embodiment, by using the signal synchronization module, the system for clock synchronization performs signal synchronization on the target clock signal via one or more stages of DFFs, in response to the instruction for signal synchronization and based on the signal for global synchronization, to obtain a synchronized clock signal. Generally, three stages of DFFs may be provided.

In this embodiment, the method for controlling signal synchronization is provided. In the foregoing scheme, after the signal for global synchronization enters the signal synchronization module in the digital-analog inter-converter, one or more stages of DFFs relock the signal for global synchronization to the target clock signal having a low-jitter. Thereby, signal delay is reduced, and signal synchronization is more precise.

A computer-readable storage medium is further provided according an embodiment of the present disclosure. The computer-readable storage medium stores a computer program. The computer program, when executed on a computer, configures the computer to perform the method according to the foregoing embodiments.

A computer program product is further provided according an embodiment of the present disclosure. The computer program includes instructions. The instructions, when executed on a computer, configure the computer to perform the method according to the foregoing embodiments.

A person skilled in the art can clearly understand that for convenience and conciseness of description, specific working processes of the foregoing systems, devices, and units may refer to the corresponding processes in the foregoing system embodiments, and details are not described herein again.

In the embodiments of the present disclosure, the disclosed system, apparatus, and method may be implemented in other manners. For example, the described apparatus embodiment is merely exemplary. For example, the division of the units is merely a division based on logical functions, and may be implemented in another manner in practice. For example, multiple units or components may be combined or integrated into another system, or some features may be omitted or not performed. In addition, mutual couplings, direct couplings or direct communication connections which are displayed or discussed may be implemented via some interfaces. Indirect couplings or indirect communication connections between the apparatuses or units may be implemented in electronics, mechanics, or other forms.

The units described as separate components may or may not be physically separated, and the components displayed as units may or may not be physical units. Namely, such components may be located in one place or may be distributed over multiple network units. Some or all of the units may be selected according to actual needs to achieve the objectives of the schemes in the embodiments.

In addition, functional units in embodiments of the present disclosure may be integrated into one processing unit, or each of the units may be physically separated, or two or more units may be integrated into one unit. The integrated unit may be implemented in hardware, or may be implemented as a software functional unit.

When the integrated unit is implemented as a software functional unit and sold or used as an independent product, the integrated unit may be stored in a computer-readable storage medium. Based on such understanding, an essence or a part in technical solutions, which contributes to the related technology, or all or some of the technical solutions, of the present disclosure may be implemented as a software product. The computer software product is stored in a storage medium and includes several instructions for instructing a computer device (which may be a personal computer, a server, a network device, or the like) to perform all or some of the steps of the methods described in embodiments of the present disclosure. The foregoing storage medium includes any medium that can store program code, such as a USB flash drive, a removable hard disk, a read-only memory (ROM), a random access memory (RAM), a magnetic disk, or an optical disc.

The foregoing embodiments are merely intended for describing the technical solutions of the present disclosure, but not for limiting the present disclosure.

## Claims

1. A system for clock synchronization, comprising a quantum control processor, QCP, and N digital-analog inter-converters (20), wherein each digital-analog inter-converter (20) comprises a frequency conversion module (201) and a signal synchronization module (202), the signal synchronization module (202) comprises at least one D flip-flop, DFF, and N is an integer greater than 1, and wherein:
the QCP (10) is configured to generate a signal for global synchronization and N reference clock signals, and each reference clock signal corresponds to one of the digital-analog inter-converters (20);
the QCP (10) is further configured to transmit the signal for global synchronization and each reference clock signal to the frequency conversion module (201) in the corresponding digital-analog inter-converter (20), and transmit the signal for global synchronization to the signal synchronization module (202) in each digital-analog inter-converter (20);
the frequency conversion module (201) is configured to perform frequency conversion on the received reference clock signal to obtain a target clock signal, and generate an instruction for signal synchronization according to the received global synchronization signal;
the frequency conversion module (201) is further configured to transmit the instruction for signal synchronization and the target clock signal to the signal synchronization module (202); and
the signal synchronization module (202) is configured to stabilize the signal for global synchronization via the at least one DFF by using the target clock signal and perform signal synchronization on the target clock signal based on the stabilized signal for global synchronization, in response to the instruction for signal synchronization , to obtain a synchronized clock signal.

2. The system for clock synchronization according to claim 1, wherein:
the signal synchronization module (202) comprises a first DFF, a second DFF, and a third DFF; and
an output terminal of the first DFF is coupled to an input terminal of the second DFF, and an output terminal of the second DFF is coupled to an input terminal of the third DFF, wherein the target clock signal is coupled to a clock terminal of the first DFF, the second DFF, and the third DFF.

3. The system for clock synchronization according to claim 1 or 2, wherein:
the N digital-analog inter-converters (20) comprise an arbitrary waveform generator,AWG, the AWG is one of the digital-analog inter-converters (20), the AWG comprises a digital-to-analog conversion, DAC, channel (203), the frequency conversion module (201) comprises a first frequency conversion unit (2011) and a second frequency conversion unit (2012), the signal synchronization module (202) comprises a first synchronization unit (2021) and a second synchronization unit (2022), the first synchronization unit (2021) comprises at least one DFF, and the second synchronization unit (2022) comprises at least one DFF;
the first frequency conversion unit (2011) is configured to perform frequency conversion on the received reference clock signal to obtain a first-frequency clock sub-signal, and generate a first synchronization instruction according to the received global synchronization signal, wherein the target clock signal comprises the first-frequency clock sub-signal, and the instruction for signal synchronization comprises the first synchronization instruction;
the first frequency conversion unit (2011) is further configured to transmit the first synchronization instruction and the first-frequency clock sub-signal to the first synchronization unit (2021);
the first synchronization unit (2021) is configured to perform signal synchronization on the first-frequency clock sub-signal via the at least one DFF in the first synchronization unit (2021), in response to the first synchronization instruction and based on the signal for global synchronization, to obtain a first synchronized clock sub-signal, wherein the synchronized clock signal comprises the first synchronized clock sub-signal;
the second frequency conversion unit (2012) is configured to perform frequency conversion on and delay the first synchronized clock sub-signal to obtain a second-frequency clock sub-signal, and generate a second synchronization instruction according to the received global synchronization signal, wherein the target clock signal comprises the second-frequency clock sub-signal, and the instruction for signal synchronization comprises the second synchronization instruction;
the second frequency conversion unit is further configured to transmit the second synchronization instruction and the second-frequency clock sub-signal to the second synchronization unit; and
the second synchronization unit (2022) is configured to perform signal synchronization on the second-frequency clock sub-signal via the at least one DFF in the second synchronization unit (2022), in response to the second synchronization instruction and based on the signal for global synchronization, to obtain a second synchronized clock sub-signal, wherein the synchronized clock signal comprises the second synchronized clock sub-signal.

4. The system for clock synchronization according to claim 3, wherein the AWG further comprises a field programmable gate array, FPGA, chip (204); and
the FPGA chip (204) is configured to transmit a data signal to the DAC channel (203), under control of the second synchronized clock sub-signal.

5. The system for clock synchronization according to claim 1 or 2, wherein:
the N digital-analog inter-converters (20) comprise a digital acquisition unit, DAQ, the DAQ is one of the digital-analog inter-converters (20), the DAQ comprises an analog-to-digital conversion, ADC, channel (205), the frequency conversion module (201) comprises a third frequency conversion unit (2013) and a fourth frequency conversion unit (2014), the signal synchronization module (202) comprises a third synchronization unit (2023) and a fourth synchronization unit (2024), the third synchronization unit (2023) comprises at least one DFF, and the fourth synchronization unit (2024) comprises at least one DFF;
the third frequency conversion unit (2013) is configured to perform frequency conversion on the received reference clock signal to obtain a third-frequency clock sub-signal, and generate a third synchronization instruction according to the received global synchronization signal, wherein the target clock signal comprises the third-frequency clock sub-signal, and the instruction for signal synchronization comprises the third synchronization instruction;
the third frequency conversion unit (2013) is further configured to transmit the third synchronization instruction and the third-frequency clock sub-signal to the third synchronization unit (2023);
the third synchronization unit (2023) is configured to perform signal synchronization on the third-frequency clock sub-signal via the at least one DFF in the third synchronization unit (2023), in response to the third synchronization instruction and based on the signal for global synchronization, to obtain a third synchronized clock sub-signal, wherein the synchronized clock signal comprises the third synchronized clock sub-signal;
the fourth frequency conversion unit (2014) is configured to perform frequency conversion on and delay the third synchronized clock sub-signal to obtain a fourth-frequency clock sub-signal, and generate a fourth synchronization instruction according to the received global synchronization signal, wherein the target clock signal comprises the fourth-frequency clock sub-signal, and the instruction for signal synchronization comprises the fourth synchronization instruction;
the fourth frequency conversion unit (2014) is further configured to transmit the fourth synchronization instruction and the fourth-frequency clock sub-signal to the fourth synchronization unit (2024); and
the fourth synchronization unit (2024) is configured to perform signal synchronization on the fourth-frequency clock sub-signal via the at least one DFF in the fourth synchronization unit (2024), in response to the fourth synchronization instruction and based on the signal for global synchronization, to obtain a fourth synchronized clock sub-signal, wherein the synchronized clock signal comprises the fourth synchronized clock sub-signal.

6. The system for clock synchronization according to claim 5, wherein the DAQ further comprises an FPGA chip (206); and
the FPGA chip (206) is configured to receive a data signal transmitted by the ADC channel (205), under control of the fourth synchronized clock sub-signal.

7. The system for clock synchronization according to claim 1 or 2, wherein:
the N digital-analog inter-converters (20) comprise an AWG, the AWG is one of the digital-analog inter-converters (20), the AWG comprises a DAC channel (203), the frequency conversion module (201) comprises a fifth frequency conversion unit (2015), the signal synchronization module (202) comprises a fifth synchronization unit (2025), and the fifth synchronization unit (2025) comprises at least one DFF;
the fifth frequency conversion unit (2015) is configured to perform frequency conversion and phase-locked loop processing on the received reference clock signal to obtain a fifth-frequency clock sub-signal, and generate a fifth synchronization instruction according to the received global synchronization signal, wherein the target clock signal comprises the fifth-frequency clock sub-signal, and the instruction for signal synchronization comprises the fifth synchronization instruction;
the fifth frequency conversion unit (2015) is further configured to transmit the fifth synchronization instruction and the fifth-frequency clock sub-signal to the fifth synchronization unit (2025); and
the fifth synchronization unit (2025) is configured to perform signal synchronization on the fifth-frequency clock sub-signal via the at least one DFF in the fifth synchronization unit (2025), in response to the fifth synchronization instruction and based on the signal for global synchronization, to obtain a fifth synchronized clock sub-signal, wherein the synchronized clock signal comprises the fifth synchronized clock sub-signal.

8. The system for clock synchronization according to claim 7, wherein:
the AWG further comprises an FPGA chip (207), the frequency conversion module (201) further comprises a sixth frequency conversion unit (2016), the signal synchronization module (202) further comprises a sixth synchronization unit (2026), and the sixth synchronization unit (2026) comprises at least one DFF;
the sixth frequency conversion unit (2016) is configured to perform frequency conversion and phase-locked loop processing on the received reference clock signal to obtain a sixth-frequency clock sub-signal, and generate a sixth synchronization instruction according to the received global synchronization signal, wherein the target clock signal comprises the sixth-frequency clock sub-signal, and the instruction for signal synchronization comprises the sixth synchronization instruction;
the sixth frequency conversion unit (2016) is further configured to transmit the sixth synchronization instruction and the sixth-frequency clock sub-signal to the sixth synchronization unit (2026);
the sixth synchronization unit (2026) is configured to perform signal synchronization on the sixth-frequency clock sub-signal via the at least one DFF in the sixth synchronization unit (2026), in response to the sixth synchronization instruction and based on the signal for global synchronization, to obtain a sixth synchronized clock sub-signal, wherein the synchronized clock signal comprises the sixth synchronized clock sub-signal; and
the FPGA chip (207) is configured to transmit a data signal to the DAC channel (203), under control of the sixth synchronized clock sub-signal.

9. The system for clock synchronization according to claim 1 or 2, wherein:
the N digital-analog inter-converters (20) comprise a DAQ, the DAQ is one of the digital-analog inter-converters (20), the DAQ comprises an ADC channel (205), the frequency conversion module (201) comprises a seventh frequency conversion unit (2017), the signal synchronization module (202) comprises a seventh synchronization unit (2027), and the seventh synchronization unit (2027) comprises at least one DFF;
the seventh frequency conversion unit (2017) is configured to perform frequency conversion and phase-locked loop processing on the received reference clock signal to obtain a seventh-frequency clock sub-signal, and generate a seventh synchronization instruction according to the received global synchronization signal, wherein the target clock signal comprises the seventh-frequency clock sub-signal, and the instruction for signal synchronization comprises the seventh synchronization instruction;
the seventh frequency conversion unit (2017) is further configured to transmit the seventh synchronization instruction and the seventh-frequency clock sub-signal to the seventh synchronization unit (2027); and
the seventh synchronization unit (2027) is configured to perform signal synchronization on the seventh-frequency clock sub-signal via the at least one DFF in the seventh synchronization unit (2027), in response to the seventh synchronization instruction and based on the signal for global synchronization, to obtain a seventh synchronized clock sub-signal, wherein the synchronized clock signal comprises the seventh synchronized clock sub-signal.

10. The system for clock synchronization according to claim 9, wherein:
the DAQ further comprises an FPGA chip (208), the frequency conversion module (201) comprises an eighth frequency conversion unit (2018), the signal synchronization module (202) comprises an eighth synchronization unit (2028), and the eighth synchronization unit (2028) comprises at least one DFF;
the eighth frequency conversion unit (2018) is configured to perform frequency conversion and phase-locked loop processing on the received reference clock signal to obtain an eighth-frequency clock sub-signal, and generate an eighth synchronization instruction according to the received global synchronization signal, wherein the target clock signal comprises the eighth-frequency clock sub-signal, and the instruction for signal synchronization comprises the eighth synchronization instruction;
the eighth frequency conversion unit (2018) is further configured to transmit the eighth synchronization instruction and the eighth-frequency clock sub-signal to the eighth synchronization unit (2028);
the eighth synchronization unit (2028) is configured to perform signal synchronization on the eighth-frequency clock sub-signal via the at least one DFF in the eighth synchronization unit (2028), in response to the eighth synchronization instruction and based on the signal for global synchronization, to obtain an eighth synchronized clock sub-signal, wherein the synchronized clock signal comprises the eighth synchronized clock sub-signal; and
the FPGA chip (208) is configured to receive a data signal transmitted by the ADC channel (205), under control of the eighth synchronized clock sub-signal.

11. The system for clock synchronization according to claim 1, wherein:
the system further comprises a chassis, the N digital-analog inter-converters comprise P pairs of AWGs and Q pairs of DAQs, each pair of AWGs comprises two AWGs, each pair of DAQs comprises two DAQs, and Q and P are both integers greater than or equal to 1;
the QCP (10), the P pairs of AWGs, and the Q pairs of DAQs are all disposed inside the chassis;
each pair of AWGs is symmetrically disposed with respect to the QCP (10); and
each pair of DAQs is symmetrically disposed with respect to the QCP (10).

12. The system for clock synchronization according to claim 1, wherein:
the N digital-analog inter-converters (20) comprise an AWG and a DAQ, the AWG comprises a DAC channel, and the DAQ comprises an ADC channel;
the QCP (10) is further configured to load a code file for FPGA chips, wherein the code file comprises a first register parameter, a second register parameter, a third register parameter, and a fourth register parameter;
the AWG is configured to write the first register parameter into the frequency conversion module in the AWG;
the DAQ is configured to write the second register parameter into the frequency conversion module in the DAQ;
the AWG is further configured to write the third register parameter into the DAC channel in the AWG; and
the DAQ is further configured to write the fourth register parameter into the ADC channel in the DAQ.

13. A method for controlling signal synchronization, applied to a system for clock synchronization, wherein the system comprises a quantum control processor, QCP, and N digital-analog inter-converters, each digital-analog inter-converter comprises a frequency conversion module and a signal synchronization module, the signal synchronization module comprises at least one D flip-flop, DFF, and N being an integer greater than 1;
wherein the method comprises:
generating (401), by the QCP, a signal for global synchronization and N reference clock signals, wherein each reference clock signal corresponds to one of the digital-analog inter-converters;
transmitting (402), by the QCP, the signal for global synchronization and each reference clock signal to the frequency conversion module in the corresponding digital-analog inter-converter;
transmitting (402), by the QCP, the signal for global synchronization to the signal synchronization module in each digital-analog inter-converter;
performing (403), by the frequency conversion module, frequency conversion on the received reference clock signal to obtain a target clock signal;
generating (403), by the frequency conversion module, an instruction for signal synchronization according to the received global synchronization signal;
transmitting (404), by the frequency conversion module, the instruction for signal synchronization and the target clock signal to the signal synchronization module; and
stabilizing, by the signal synchronization module, the signal for global synchronization via the at least one DFF by using the target clock signal, and performing (405), by the signal synchronization module, signal synchronization on the target clock signal based on the stabilized signal for global synchronization, in response to the instruction for signal synchronization, to obtain a synchronized clock signal.

14. A computer-readable storage medium, storing a computer program, wherein the computer program comprises instructions that, when executed on a computer, configure the computer to perform the method according to claim 13.

15. A computer program product, comprising instructions, wherein the instructions when executed on a computer configure the computer to perform the method according to claim 13.

## Patentansprüche

1. System für eine Taktsynchronisation, das einen Quantensteuerprozessor, QCP, und N Digital-Analog-Interconverter (20) umfasst, wobei jeder Digital-Analog-Interconverter (20) ein Frequenzumwandlungsmodul (201) und ein Signalsynchronisationsmodul (202) umfasst, wobei das Signalsynchronisationsmodul (202) mindestens ein D-Flip-Flop, DFF, umfasst und N eine Ganzzahl größer als 1 ist, und wobei:
der QCP (10) dazu ausgelegt ist, ein Signal für eine globale Synchronisation und N Referenztaktsignale zu erzeugen, und jedes Referenztaktsignal einem der Digital-Analog-Interconverter (20) entspricht;
der QCP (10) ferner dazu ausgelegt ist, das Signal für eine globale Synchronisation und jedes Referenztaktsignal zum Frequenzumwandlungsmodul (201) im entsprechenden Digital-Analog-Interconverter (20) zu übertragen und das Signal für eine globale Synchronisation zum Signalsynchronisationsmodul (202) in jedem Digital-Analog-Interconverter (20) zu übertragen;
das Frequenzumwandlungsmodul (201) dazu ausgelegt ist, Frequenzumwandlungen am empfangenen Referenztaktsignal durchzuführen, um ein Zieltaktsignal zu erhalten, und eine Anweisung für eine Signalsynchronisation gemäß dem empfangenen globalen Synchronisationssignal zu erzeugen;
das Frequenzumwandlungsmodul (201) ferner dazu ausgelegt ist, die Anweisung für eine Signalsynchronisation und das Zieltaktsignal zum Signalsynchronisationsmodul (202) zu übertragen; und
das Signalsynchronisationsmodul (202) dazu ausgelegt ist, das Signal für eine globale Synchronisation via das mindestens eine DFF unter Verwendung des Zieltaktsignals zu stabilisieren und auf in Reaktion auf die Anweisung für eine Signalsynchronisation eine Signalsynchronisation am Zieltaktsignal auf Basis des stabilisierten Signals für eine globale Synchronisation durchzuführen, um ein synchronisiertes Taktsignal zu erhalten.

2. System für eine Taktsynchronisation nach Anspruch 1, wobei:
das Signalsynchronisationsmodul (202) ein erstes DFF, ein zweites DFF und ein drittes DFF umfasst; und
ein Ausgangsanschluss des ersten DFF an einen Eingangsanschluss des zweiten DFF gekoppelt ist und ein Ausgangsanschluss des zweiten DFF an einen Eingangsanschluss des dritten DFF gekoppelt ist, wobei das Zieltaktsignal an einen Taktanschluss des ersten DFF, des zweiten DFF und des dritten DFF gekoppelt ist.

3. System für eine Taktsynchronisation nach Anspruch 1 oder 2, wobei:
die N Digital-Analog-Interconverter (20) einen Arbiträrgenerator, AWG, umfassen, der AWG einer der Digital-Analog-Interconverter (20) ist, der AWG einen Digital-zu-Analog-Umwandlungs(DAC)-Kanal (203) umfasst, das Frequenzumwandlungsmodul (201) eine erste Frequenzumwandlungseinheit (2011) und eine zweite Frequenzumwandlungseinheit (2012) umfasst, das Signalsynchronisationsmodul (202) eine erste Synchronisationseinheit (2021) und eine zweite Synchronisationseinheit (2022) umfasst, die erste Synchronisationseinheit (2021) mindestens ein DFF umfasst und die zweite Synchronisationseinheit (2022) mindestens ein DFF umfasst;
die erste Frequenzumwandlungseinheit (2011) dazu ausgelegt ist, am empfangenen Referenztaktsignal eine Frequenzumwandlung durchzuführen, um ein Taktuntersignal einer ersten Frequenz zu erhalten, und eine erste Synchronisationsanweisung gemäß dem empfangenen globalen Synchronisationssignal zu erzeugen, wobei das Zieltaktsignal das Taktuntersignal der ersten Frequenz umfasst und die Anweisung für eine Signalsynchronisation die erste Synchronisationsanweisung umfasst;
die erste Frequenzumwandlungseinheit (2011) ferner dazu ausgelegt ist, die erste Synchronisationsanweisung und das Taktuntersignal der ersten Frequenz zur ersten Synchronisationseinheit (2021) zu übertragen;
die erste Synchronisationseinheit (2021) dazu ausgelegt ist, via das mindestens eine DFF in der ersten Synchronisationseinheit (2021) in Reaktion auf die erste Synchronisationsanweisung und auf Basis des Signals für eine globale Synchronisation eine Signalsynchronisation am Taktuntersignal der ersten Frequenz durchzuführen, um ein erstes synchronisiertes Taktuntersignal zu erhalten, wobei das synchronisierte Taktsignal das erste synchronisierte Taktuntersignal umfasst;
die zweite Frequenzumwandlungseinheit (2012) dazu ausgelegt ist, am ersten synchronisierten Taktuntersignal eine Frequenzumwandlung durchzuführen und dasselbe zu verzögern, um ein Taktuntersignal einer zweiten Frequenz zu erhalten, und eine zweite Synchronisationsanweisung gemäß dem empfangenen globalen Synchronisationssignal zu erzeugen, wobei das Zieltaktsignal das Taktuntersignal der zweiten Frequenz umfasst und die Anweisung für eine Signalsynchronisation die zweite Synchronisationsanweisung umfasst;
die zweite Frequenzumwandlungseinheit ferner dazu ausgelegt ist, die zweite Synchronisationsanweisung und das Taktuntersignal der zweiten Frequenz zur zweiten Synchronisationseinheit zu übertragen; und
die zweite Synchronisationseinheit (2022) dazu ausgelegt ist, via das mindestens eine DFF in der zweiten Synchronisationseinheit (2022) in Reaktion auf die zweite Synchronisationsanweisung und auf Basis des Signals für eine globale Synchronisation eine Signalsynchronisation am Taktuntersignal der zweiten Frequenz durchzuführen, um ein zweites synchronisiertes Taktuntersignal zu erhalten, wobei das synchronisierte Taktsignal das zweite synchronisierte Taktuntersignal umfasst.

4. System für eine Taktsynchronisation nach Anspruch 3, wobei der AWG einen Chip (204) mit einem feldprogrammierbaren Gatearray, FPGA, umfasst; und
der FPGA-Chip (204) ist dazu ausgelegt, ein Datensignal unter Steuerung des zweiten synchronisierten Taktuntersignals zum DAC-Kanal (203) zu übertragen.

5. System für eine Taktsynchronisation nach Anspruch 1 oder 2, wobei:
die N Digital-Analog-Interconverter (20) eine digitale Erfassungseinheit, DAQ, umfassen, die DAQ eine der Digital-Analog-Interconverter (20) ist, die DAQ einen Analog-zu-Digital-Umwandlungs(ADC)-Kanal (205) umfasst, das Frequenzumwandlungsmodul (201) eine dritte Frequenzumwandlungseinheit (2013) und eine vierte Frequenzumwandlungseinheit (2014) umfasst, das Signalsynchronisationsmodul (202) eine dritte Synchronisationseinheit (2023) und eine vierte Synchronisationseinheit (2024) umfasst, die dritte Synchronisationseinheit (2023) mindestens ein DFF umfasst und die vierte Synchronisationseinheit (2024) mindestens ein DFF umfasst;
die dritte Frequenzumwandlungseinheit (2013) dazu ausgelegt ist, am empfangenen Referenztaktsignal eine Frequenzumwandlung durchzuführen, um ein Taktuntersignal einer dritten Frequenz zu erhalten, und eine dritte Synchronisationsanweisung gemäß dem empfangenen globalen Synchronisationssignal zu erzeugen, wobei das Zieltaktsignal das Taktuntersignal der dritten Frequenz umfasst und die Anweisung für eine Signalsynchronisation die dritte Synchronisationsanweisung umfasst;
die dritte Frequenzumwandlungseinheit (2013) ferner dazu ausgelegt ist, die dritte Synchronisationsanweisung und das Taktuntersignal der dritten Frequenz zur dritten Synchronisationseinheit (2023) zu übertragen;
die dritte Synchronisationseinheit (2023) dazu ausgelegt ist, via das mindestens eine DFF in der dritten Synchronisationseinheit (2023) in Reaktion auf die dritte Synchronisationsanweisung und auf Basis des Signals für eine globale Synchronisation eine Signalsynchronisation am Taktuntersignal der dritten Frequenz durchzuführen, um ein drittes synchronisiertes Taktuntersignal zu erhalten, wobei das synchronisierte Taktsignal das dritte synchronisierte Taktuntersignal umfasst;
die vierte Frequenzumwandlungseinheit (2014) dazu ausgelegt ist, am dritten synchronisierten Taktuntersignal eine Frequenzumwandlung durchzuführen und dasselbe zu verzögern, um ein Taktuntersignal einer vierten Frequenz zu erhalten, und eine vierte Synchronisationsanweisung gemäß dem empfangenen globalen Synchronisationssignal zu erzeugen, wobei das Zieltaktsignal das Taktuntersignal der vierten Frequenz umfasst und die Anweisung für eine Signalsynchronisation die vierte Synchronisationsanweisung umfasst;
die vierte Frequenzumwandlungseinheit (2014) ferner dazu ausgelegt ist, die vierte Synchronisationsanweisung und das Taktuntersignal der vierten Frequenz zur vierten Synchronisationseinheit (2024) zu übertragen; und
die vierte Synchronisationseinheit (2024) dazu ausgelegt ist, via das mindestens eine DFF in der vierten Synchronisationseinheit (2024) in Reaktion auf die vierte Synchronisationsanweisung und auf Basis des Signals für eine globale Synchronisation eine Signalsynchronisation am Taktuntersignal der vierten Frequenz durchzuführen, um ein viertes synchronisiertes Taktuntersignal zu erhalten, wobei das synchronisierte Taktsignal das vierte synchronisierte Taktuntersignal umfasst.

6. System für eine Taktsynchronisation nach Anspruch 5, wobei die DAQ ferner einen FPGA-Chip (206) umfasst; und
der FPGA-Chip (206) ist dazu ausgelegt, ein Datensignal, das vom ADC-Kanal (205) übertragen wird, unter Steuerung des vierten synchronisierten Taktuntersignals zu empfangen.

7. System für eine Taktsynchronisation nach Anspruch 1 oder 2, wobei:
die N Digital-Analog-Interconverter (20) einen AWG umfassen, der AWG einer der Digital-Analog-Interconverter (20) ist, der AWG einen DAC-Kanal (203) umfasst, das Frequenzumwandlungsmodul (201) eine fünfte Frequenzumwandlungseinheit (2015) umfasst, das Signalsynchronisationsmodul (202) eine fünfte Synchronisationseinheit (2025) umfasst und die fünfte Synchronisationseinheit (2025) mindestens ein DFF umfasst;
die fünfte Frequenzumwandlungseinheit (2015) dazu ausgelegt ist, eine Frequenzumwandlung und eine Phasenregelschleifenverarbeitung am empfangenen Referenztaktsignal durchzuführen, um ein Taktuntersignal einer fünften Frequenz zu erhalten, und eine fünfte Synchronisationsanweisung gemäß dem empfangenen globalen Synchronisationssignal zu erzeugen, wobei das Zieltaktsignal das Taktuntersignal der fünften Frequenz umfasst und die Anweisung für eine Signalsynchronisation die fünfte Synchronisationsanweisung umfasst;
die fünfte Frequenzumwandlungseinheit (2015) ferner dazu ausgelegt ist, die fünfte Synchronisationsanweisung und das Taktuntersignal der fünften Frequenz zur fünften Synchronisationseinheit (2025) zu übertragen; und
die fünfte Synchronisationseinheit (2025) dazu ausgelegt ist, via das mindestens eine DFF in der fünften Synchronisationseinheit (2025) in Reaktion auf die fünfte Synchronisationsanweisung und auf Basis des Signals für eine globale Synchronisation eine Signalsynchronisation am Taktuntersignal der fünften Frequenz durchzuführen, um ein fünftes synchronisiertes Taktuntersignal zu erhalten, wobei das synchronisierte Taktsignal das fünfte synchronisierte Taktuntersignal umfasst.

8. System für eine Taktsynchronisation nach Anspruch 7, wobei:
der AWG ferner einen FPGA-Chip (207) umfasst, das Frequenzumwandlungsmodul (201) ferner eine sechste Frequenzumwandlungseinheit (2016) umfasst, das Signalsynchronisationsmodul (202) ferner eine sechste Synchronisationseinheit (2026) umfasst und die sechste Synchronisationseinheit (2026) mindestens ein DFF umfasst;
die sechste Frequenzumwandlungseinheit (2016) dazu ausgelegt ist, eine Frequenzumwandlung und eine Phasenregelschleifenverarbeitung am empfangenen Referenztaktsignal durchzuführen, um ein Taktuntersignal einer sechsten Frequenz zu erhalten, und eine sechste Synchronisationsanweisung gemäß dem empfangenen globalen Synchronisationssignal zu erzeugen, wobei das Zieltaktsignal das Taktuntersignal der sechsten Frequenz umfasst und die Anweisung für eine Signalsynchronisation die sechste Synchronisationsanweisung umfasst;
die sechste Frequenzumwandlungseinheit (2016) ferner dazu ausgelegt ist, die sechste Synchronisationsanweisung und das Taktuntersignal der sechsten Frequenz zur sechsten Synchronisationseinheit (2026) zu übertragen;
die sechste Synchronisationseinheit (2026) dazu ausgelegt ist, via das mindestens eine DFF in der sechsten Synchronisationseinheit (2026) in Reaktion auf die sechste Synchronisationsanweisung und auf Basis des Signals für eine globale Synchronisation eine Signalsynchronisation am Taktuntersignal der sechsten Frequenz durchzuführen, um ein sechstes synchronisiertes Taktuntersignal zu erhalten, wobei das synchronisierte Taktsignal das sechste synchronisierte Taktuntersignal umfasst; und
der FPGA-Chip (207) dazu ausgelegt ist, ein Datensignal unter Steuerung des sechsten synchronisierten Taktuntersignals zum DAC-Kanal (203) zu übertragen.

9. System für eine Taktsynchronisation nach Anspruch 1 oder 2, wobei:
die N Digital-Analog-Interconverter (20) eine DAQ umfassen, die DAQ einer der Digital-Analog-Interconverter (20) ist, die DAQ einen ADC-Kanal (205) umfasst, das Frequenzumwandlungsmodul (201) eine siebte Frequenzumwandlungseinheit (2017) umfasst, das Signalsynchronisationsmodul (202) eine siebte Synchronisationseinheit (2027) umfasst und die siebte Synchronisationseinheit (2027) mindestens ein DFF umfasst;
die siebte Frequenzumwandlungseinheit (2017) dazu ausgelegt ist, eine Frequenzumwandlung und eine Phasenregelschleifenverarbeitung am empfangenen Referenztaktsignal durchzuführen, um ein Taktuntersignal einer siebten Frequenz zu erhalten, und eine siebte Synchronisationsanweisung gemäß dem empfangenen globalen Synchronisationssignal zu erzeugen, wobei das Zieltaktsignal das Taktuntersignal der siebten Frequenz umfasst und die Anweisung für eine Signalsynchronisation die siebte Synchronisationsanweisung umfasst;
die siebte Frequenzumwandlungseinheit (2017) ferner dazu ausgelegt ist, die siebte Synchronisationsanweisung und das Taktuntersignal der siebten Frequenz zur siebten Synchronisationseinheit (2027) zu übertragen; und
die siebte Synchronisationseinheit (2027) dazu ausgelegt ist, via das mindestens eine DFF in der siebten Synchronisationseinheit (2027) in Reaktion auf die siebte Synchronisationsanweisung und auf Basis des Signals für eine globale Synchronisation eine Signalsynchronisation am Taktuntersignal der siebten Frequenz durchzuführen, um ein siebtes synchronisiertes Taktuntersignal zu erhalten, wobei das synchronisierte Taktsignal das siebte synchronisierte Taktuntersignal umfasst.

10. System für eine Taktsynchronisation nach Anspruch 9, wobei:
die DAQ ferner einen FPGA-Chip (208) umfasst, das Frequenzumwandlungsmodul (201) eine achte Frequenzumwandlungseinheit (2018) umfasst, das Signalsynchronisationsmodul (202) eine achte Synchronisationseinheit (2028) umfasst und die achte Synchronisationseinheit (2028) mindestens ein DFF umfasst;
die achte Frequenzumwandlungseinheit (2018) dazu ausgelegt ist, eine Frequenzumwandlung und eine Phasenregelschleifenverarbeitung am empfangenen Referenztaktsignal durchzuführen, um ein Taktuntersignal einer achten Frequenz zu erhalten, und eine achte Synchronisationsanweisung gemäß dem empfangenen globalen Synchronisationssignal zu erzeugen, wobei das Zieltaktsignal das Taktuntersignal der achten Frequenz umfasst und die Anweisung für eine Signalsynchronisation die achte Synchronisationsanweisung umfasst;
die achte Frequenzumwandlungseinheit (2018) ferner dazu ausgelegt ist, die achte Synchronisationsanweisung und das Taktuntersignal der achten Frequenz zur achten Synchronisationseinheit (2028) zu übertragen;
die achte Synchronisationseinheit (2028) dazu ausgelegt ist, via das mindestens eine DFF in der achten Synchronisationseinheit (2028) in Reaktion auf die achte Synchronisationsanweisung und auf Basis des Signals für eine globale Synchronisation eine Signalsynchronisation am Taktuntersignal der achten Frequenz durchzuführen, um ein achtes synchronisiertes Taktuntersignal zu erhalten, wobei das synchronisierte Taktsignal das achte synchronisierte Taktuntersignal umfasst; und
der FPGA-Chip (208) dazu ausgelegt ist, ein Datensignal, das vom ADC-Kanal (205) übertragen wird, unter Steuerung des achten synchronisierten Taktuntersignals zu empfangen.

11. System für eine Taktsynchronisation nach Anspruch 1, wobei:
das System ferner ein Gehäuse umfasst, die N Digital-Analog-Interconverter P Paare von AWGs und Q Paare von DAQs umfassen, jedes Paar von AWGs zwei AWGs umfasst, jedes Paar von DAQs zwei DAQs umfasst und Q und P beides Ganzzahlen größer als oder gleich 1 sind;
der QCP (10), die P Paare von AWGs und die Q Paare von DAQs alle im Gehäuse angeordnet sind;
jedes Paar von AWGs mit Bezug auf den QCP (10) symmetrisch angeordnet ist; und
jedes Paar von DAQs mit Bezug auf den QCP (10) symmetrisch angeordnet ist.

12. System für eine Taktsynchronisation nach Anspruch 1, wobei:
die N Digital-Analog-Interconverter (20) einen AWG und eine DAQ umfassen, der AWG einen DAC-Kanal umfasst und die DAQ einen ADC-Kanal umfasst;
der QCP (10) ferner dazu ausgelegt ist, eine Codedatei für FPGA-Chips zu laden, wobei die Codedatei einen ersten Registerparameter, einen zweiten Registerparameter, einen dritten Registerparameter und einen vierten Registerparameter umfasst;
der AWG dazu ausgelegt ist, den ersten Registerparameter in das Frequenzumwandlungsmodul im AWG zu schreiben;
die DAQ dazu ausgelegt ist, den zweiten Registerparameter in das Frequenzumwandlungsmodul in der DAQ zu schreiben;
der AWG ferner dazu ausgelegt ist, den dritten Registerparameter in den DAC-Kanal im AWG zu schreiben; und
die DAQ ferner dazu ausgelegt ist, den vierten Registerparameter in den ADC-Kanal in der DAQ zu schreiben.

13. Verfahren zum Steuern einer Signalsynchronisation, das auf ein System für eine Taktsynchronisation angewandt wird, wobei das System einen Quantensteuerprozessor, QCP, und N Digital-Analog-Interconverter umfasst, wobei jeder Digital-Analog-Interconverter ein Frequenzumwandlungsmodul und ein Signalsynchronisationsmodul umfasst, das Signalsynchronisationsmodul mindestens ein D-Flip-Flop, DFF, umfasst und N eine Ganzzahl größer als 1 ist;
wobei das Verfahren Folgendes umfasst:
Erzeugen (401) eines Signals für eine globale Synchronisation und von N Referenztaktsignalen durch den QCP, wobei jedes Referenztaktsignal einem der Digital-Analog-Interconverter entspricht;
Übertragen (402) des Signals für eine globale Synchronisation und jedes Referenztaktsignals durch den QCP zum Frequenzumwandlungsmodul im entsprechenden Digital-Analog-Interconverter;
Übertragen (402) des Signals für eine globale Synchronisation durch den QCP zum Signalsynchronisationsmodul in jedem Digital-Analog-Interconverter;
Durchführen (403) einer Frequenzumwandlung am empfangenen Referenztaktsignal durch das Frequenzumwandlungsmodul, um ein Zieltaktsignal zu erhalten;
Erzeugen (403) einer Anweisung für eine Signalsynchronisation durch das Frequenzumwandlungsmodul gemäß dem empfangenen globalen Synchronisationssignal;
Übertragen (404) der Anweisung für eine Signalsynchronisation und des Zieltaktsignals durch das Frequenzumwandlungsmodul zum Signalsynchronisationsmodul; und
Stabilisieren des Signals für eine globale Synchronisation durch das Signalsynchronisationsmodul via das mindestens eine DFF unter Verwendung des Zieltaktsignals und Durchführen (405) einer Signalsynchronisation durch das Signalsynchronisationsmodul am Zieltaktsignal auf Basis des stabilisierten Signals für eine globale Synchronisation in Reaktion auf die Anweisung für eine Signalsynchronisation, um ein synchronisiertes Taktsignal zu erhalten.

14. Computerlesbares Speichermedium, auf dem ein Computerprogramm gespeichert ist, wobei das Computerprogramm Anweisungen umfasst, die, wenn sie auf einem Computer ausgeführt werden, den Computer dazu auslegen, das Verfahren nach Anspruch 13 durchzuführen.

15. Computerprogrammprodukt, das Anweisungen umfasst, wobei die Anweisungen, wenn sie auf einem Computer ausgeführt werden, den Computer dazu auslegen, das Verfahren nach Anspruch 13 durchzuführen.

## Revendications

1. Système de synchronisation d'horloge comprenant un processeur de commande quantique, QCP, et N convertisseurs inter numérique-analogique (20), dans lequel chaque convertisseur inter numérique-analogique (20) comprend un module de conversion de fréquence (201) et un module de synchronisation de signal (202), le module de synchronisation de signal (202) comprend au moins une bascule D, DFF, et N est un entier supérieur à 1, et dans lequel :
le QCP (10) est configuré pour générer un signal de synchronisation global et N signaux d'horloge de référence, et chaque signal d'horloge de référence correspond à l'un des convertisseurs inter numérique-analogique (20) ;
le QCP (10) est en outre configuré pour transmettre le signal de synchronisation global et chaque signal d'horloge de référence au module de conversion de fréquence (201) dans le convertisseur inter numérique-analogique (20) correspondant, et transmettre le signal de synchronisation global au module de synchronisation de signal (202) dans chaque convertisseur inter numérique-analogique (20) ;
le module de conversion de fréquence (201) est configuré pour effectuer une conversion de fréquence sur le signal d'horloge de référence reçu afin d'obtenir un signal d'horloge cible, et générer une instruction de synchronisation de signal selon le signal de synchronisation global reçu ;
le module de conversion de fréquence (201) est en outre configuré pour transmettre l'instruction de synchronisation de signal et le signal d'horloge cible au module de synchronisation de signal (202) ; et
le module de synchronisation de signal (202) est configuré pour stabiliser le signal de synchronisation global via l'au moins une DFF en utilisant le signal d'horloge cible, et effectuer une synchronisation de signal sur le signal d'horloge cible sur la base du signal stabilisé pour une synchronisation globale en réponse à l'instruction de synchronisation de signal afin d'obtenir un signal d'horloge synchronisé.

2. Système de synchronisation d'horloge selon la revendication 1, dans lequel :
le module de synchronisation de signal (202) comprend une première DFF, une deuxième DFF et une troisième DFF ; et
une borne de sortie de la première DFF est couplée à une borne d'entrée de la deuxième DFF, et une borne de sortie de la deuxième DFF est couplée à une borne d'entrée de la troisième DFF, dans lequel le signal d'horloge cible est couplé à une borne d'horloge de la première DFF, de la deuxième DFF et de la troisième DFF.

3. Système de synchronisation d'horloge selon la revendication 1 ou 2, dans lequel :
les N convertisseurs inter numérique-analogique (20) comprennent un générateur de forme d'onde arbitraire, AWG, l'AWG est l'un des convertisseurs inter numérique-analogique (20), l'AWG comprend un canal de conversion numérique-analogique, DAC, (203), le module de conversion de fréquence (201) comprend une première unité de conversion de fréquence (2011) et une deuxième unité de conversion de fréquence (2012), le module de synchronisation de signal (202) comprend une première unité de synchronisation (2021) et une deuxième unité de synchronisation (2022), la première unité de synchronisation (2021) comprend au moins une DFF, et la deuxième unité de synchronisation (2022) comprend au moins une DFF ;
la première unité de conversion de fréquence (2011) est configurée pour effectuer une conversion de fréquence sur le signal d'horloge de référence reçu afin d'obtenir un sous-signal d'horloge de première fréquence, et générer une première instruction de synchronisation selon le signal de synchronisation global reçu, dans lequel le signal d'horloge cible comprend le sous-signal d'horloge de première fréquence, et l'instruction de synchronisation de signal comprend la première instruction de synchronisation ;
la première unité de conversion de fréquence (2011) est en outre configurée pour transmettre la première instruction de synchronisation et le sous-signal d'horloge de première fréquence à la première unité de synchronisation (2021) ;
la première unité de synchronisation (2021) est configurée pour effectuer une synchronisation de signal sur le sous-signal d'horloge de première fréquence via l'au moins une DFF dans la première unité de synchronisation (2021), en réponse à la première instruction de synchronisation et sur la base du signal de synchronisation global, afin d'obtenir un premier sous-signal d'horloge synchronisé, dans lequel le signal d'horloge synchronisé comprend le premier sous-signal d'horloge synchronisé ;
la deuxième unité de conversion de fréquence (2012) est configurée pour effectuer une conversion de fréquence sur le premier sous-signal d'horloge synchronisé et le retarder afin d'obtenir un signal d'horloge de deuxième fréquence, et générer une deuxième instruction de synchronisation selon le signal de synchronisation global reçu, dans lequel le signal d'horloge cible comprend le signal d'horloge de deuxième fréquence, et l'instruction de synchronisation de signal comprend la deuxième instruction de synchronisation ;
la deuxième unité de conversion de fréquence est en outre configurée pour transmettre la deuxième instruction de synchronisation et le signal d'horloge de deuxième fréquence à la deuxième unité de synchronisation ; et
la deuxième unité de synchronisation (2022) est configurée pour effectuer une synchronisation de signal sur le signal d'horloge de deuxième fréquence via l'au moins une DFF dans la deuxième unité de synchronisation (2022), en réponse à la deuxième instruction de synchronisation et sur la base du signal de synchronisation global, afin d'obtenir un deuxième sous-signal d'horloge synchronisé, dans lequel le signal d'horloge synchronisé comprend le deuxième sous-signal d'horloge synchronisé.

4. Système de synchronisation d'horloge selon la revendication 3, dans lequel l'AWG comprend en outre une puce de réseau de porte programmable par l'utilisateur, FPGA, (204) ; et
la puce FPGA (204) est configurée pour transmettre un signal de données au canal DAC (203) sous la commande du deuxième sous-signal d'horloge synchronisé.

5. Système de synchronisation d'horloge selon la revendication 1 ou 2, dans lequel :
les N convertisseurs inter numérique-analogique (20) comprennent une unité d'acquisition numérique, DAQ, la DAQ est l'un des convertisseurs inter numérique-analogique (20), la DAQ comprend un canal de conversion analogique-numérique, ADC, (205), le module de conversion de fréquence (201) comprend une troisième unité de conversion de fréquence (2013) et une quatrième unité de conversion de fréquence (2014), le module de synchronisation de signal (202) comprend une troisième unité de synchronisation (2023) et une quatrième unité de synchronisation (2024), la troisième unité de synchronisation (2023) comprend au moins une DFF, et la quatrième unité de synchronisation (2024) comprend au moins une DFF ;
la troisième unité de conversion de fréquence (2013) est configurée pour effectuer une conversion de fréquence sur le signal d'horloge de référence reçu afin d'obtenir un sous-signal d'horloge de troisième fréquence, et générer une troisième instruction de synchronisation selon le signal de synchronisation global reçu, dans lequel le signal d'horloge cible comprend le sous-signal d'horloge de troisième fréquence, et l'instruction de synchronisation de signal comprend la troisième instruction de synchronisation ;
la troisième unité de conversion de fréquence (2013) est en outre configurée pour transmettre la troisième instruction de synchronisation et le sous-signal d'horloge de troisième fréquence à la troisième unité de synchronisation (2023) ;
la troisième unité de synchronisation (2023) est configurée pour effectuer une synchronisation de signal sur le sous-signal d'horloge de troisième fréquence via l'au moins une DFF dans la troisième unité de synchronisation (2023), en réponse à la troisième instruction de synchronisation et sur la base du signal de synchronisation global, afin d'obtenir un troisième sous-signal d'horloge synchronisé, dans lequel le signal d'horloge synchronisé comprend le troisième sous-signal d'horloge synchronisé ;
la quatrième unité de conversion de fréquence (2014) est configurée pour effectuer une conversion de fréquence sur le troisième sous-signal d'horloge synchronisé et le retarder afin d'obtenir un sous-signal d'horloge de quatrième fréquence, et générer une quatrième instruction de synchronisation selon le signal de synchronisation global reçu, dans lequel le signal d'horloge cible comprend le sous-signal d'horloge de quatrième fréquence, et l'instruction de synchronisation de signal comprend la quatrième instruction de synchronisation ;
la quatrième unité de conversion de fréquence (2014) est en outre configurée pour transmettre la quatrième instruction de synchronisation et le sous-signal d'horloge de quatrième fréquence à la quatrième unité de synchronisation (2024) ; et
la quatrième unité de synchronisation (2024) est configurée pour effectuer une synchronisation de signal sur le sous-signal d'horloge de quatrième fréquence via l'au moins une DFF dans la quatrième unité de synchronisation (2024), en réponse à la quatrième instruction de synchronisation et sur la base du signal de synchronisation global, afin d'obtenir un quatrième sous-signal d'horloge synchronisé, dans lequel le signal d'horloge synchronisé comprend le quatrième sous-signal d'horloge synchronisé.

6. Système de synchronisation d'horloge selon la revendication 5, dans lequel la DAQ comprend en outre une puce FPGA (206) ; et
la puce FPGA (206) est configurée pour recevoir un signal de données transmis par le canal ADC (205) sous la commande du quatrième sous-signal d'horloge synchronisé.

7. Système de synchronisation d'horloge selon la revendication 1 ou 2, dans lequel :
les N convertisseurs inter numérique-analogique (20) comprennent un AWG, l'AWG est l'un des convertisseurs inter numérique-analogique (20), l'AWG comprend un canal DAC (203), le module de conversion de fréquence (201) comprend une cinquième unité de conversion de fréquence (2015), le module de synchronisation de signal (202) comprend une cinquième unité de synchronisation (2025), et la cinquième unité de synchronisation (2025) comprend au moins une DFF ;
la cinquième unité de conversion de fréquence (2015) est configurée pour effectuer une conversion de fréquence et un traitement en boucle à verrouillage de phase sur le signal d'horloge de référence reçu afin d'obtenir un sous-signal d'horloge de cinquième fréquence, et générer une cinquième instruction de synchronisation selon le signal de synchronisation global reçu, dans lequel le signal d'horloge cible comprend le sous-signal d'horloge de cinquième fréquence, et l'instruction de synchronisation de signal comprend la cinquième instruction de synchronisation ;
la cinquième unité de conversion de fréquence (2015) est en outre configurée pour transmettre la cinquième instruction de synchronisation et le sous-signal d'horloge de cinquième fréquence à la cinquième unité de synchronisation (2025) ; et
la cinquième unité de synchronisation (2025) est configurée pour effectuer une synchronisation de signal sur le sous-signal d'horloge de cinquième fréquence via l'au moins une DFF dans la cinquième unité de synchronisation (2025), en réponse à la cinquième instruction de synchronisation et sur la base du signal de synchronisation global, afin d'obtenir un cinquième sous-signal d'horloge synchronisé, dans lequel le signal d'horloge synchronisé comprend le cinquième sous-signal d'horloge synchronisé.

8. Système de synchronisation d'horloge selon la revendication 7, dans lequel :
l'AWG comprend en outre une puce FPGA (207), le module de conversion de fréquence (201) comprend en outre une sixième unité de conversion de fréquence (2016), le module de synchronisation de signal (202) comprend en outre une sixième unité de synchronisation (2026), et la sixième unité de synchronisation (2026) comprend au moins une DFF ;
la sixième unité de conversion de fréquence (2016) est configurée pour effectuer une conversion de fréquence et un traitement en boucle à verrouillage de phase sur le signal d'horloge de référence reçu afin d'obtenir un sous-signal d'horloge de sixième fréquence, et générer une sixième instruction de synchronisation selon le signal de synchronisation global reçu, dans lequel le signal d'horloge cible comprend le sous-signal d'horloge de sixième fréquence, et l'instruction de synchronisation de signal comprend la sixième instruction de synchronisation ;
la sixième unité de conversion de fréquence (2016) est en outre configurée pour transmettre la sixième instruction de synchronisation et le sous-signal d'horloge de sixième fréquence à la sixième unité de synchronisation (2026) ;
la sixième unité de synchronisation (2026) est configurée pour effectuer une synchronisation de signal sur le sous-signal d'horloge de sixième fréquence via l'au moins une DFF dans la sixième unité de synchronisation (2026), en réponse à la sixième instruction de synchronisation et sur la base du signal de synchronisation global, afin d'obtenir un sixième sous-signal d'horloge synchronisé, dans lequel le signal d'horloge synchronisé comprend le sixième sous-signal d'horloge synchronisé ; et
la puce FPGA (207) est configurée pour transmettre un signal de données au canal DAC (203) sous la commande du sixième sous-signal d'horloge synchronisé.

9. Système de synchronisation d'horloge selon la revendication 1 ou 2, dans lequel :
les N convertisseurs inter numérique-analogique (20) comprennent une DAQ, la DAQ est l'un des convertisseurs inter numérique-analogique (20), la DAQ comprend un canal ADC (205), le module de conversion de fréquence (201) comprend une septième unité de conversion de fréquence (2017), le module de synchronisation de signal (202) comprend une septième unité de synchronisation (2027), et la septième unité de synchronisation (2027) comprend au moins une DFF ;
la septième unité de conversion de fréquence (2017) est configurée pour effectuer une conversion de fréquence et un traitement en boucle à verrouillage de phase sur le signal d'horloge de référence reçu afin d'obtenir un sous-signal d'horloge de septième fréquence, et générer une septième instruction de synchronisation selon le signal de synchronisation global reçu, dans lequel le signal d'horloge cible comprend le sous-signal d'horloge de septième fréquence, et l'instruction de synchronisation de signal comprend la septième instruction de synchronisation ;
la septième unité de conversion de fréquence (2017) est en outre configurée pour transmettre la septième instruction de synchronisation et le sous-signal d'horloge de septième fréquence à la septième unité de synchronisation (2027) ; et
la septième unité de synchronisation (2027) est configurée pour effectuer une synchronisation de signal sur le sous-signal d'horloge de septième fréquence via l'au moins une DFF dans la septième unité de synchronisation (2027), en réponse à la septième instruction de synchronisation et sur la base du signal de synchronisation global, afin d'obtenir un septième sous-signal d'horloge synchronisé, dans lequel le signal d'horloge synchronisé comprend le septième sous-signal d'horloge synchronisé.

10. Système de synchronisation d'horloge selon la revendication 9, dans lequel :
la DAQ comprend en outre une puce FPGA (208), le module de conversion de fréquence (201) comprend une huitième unité de conversion de fréquence (2018), le module de synchronisation de signal (202) comprend une huitième unité de synchronisation (2028), et la huitième unité de synchronisation (2028) comprend au moins une DFF ;
la huitième unité de conversion de fréquence (2018) est configurée pour effectuer une conversion de fréquence et un traitement en boucle à verrouillage de phase sur le signal d'horloge de référence reçu afin d'obtenir un sous-signal d'horloge de huitième fréquence, et générer une huitième instruction de synchronisation selon le signal de synchronisation global reçu, dans lequel le signal d'horloge cible comprend le sous-signal d'horloge de huitième fréquence, et l'instruction de synchronisation de signal comprend la huitième instruction de synchronisation ;
la huitième unité de conversion de fréquence (2018) est en outre configurée pour transmettre la huitième instruction de synchronisation et le sous-signal d'horloge de huitième fréquence à la huitième unité de synchronisation (2028) ;
la huitième unité de synchronisation (2028) est configurée pour effectuer une synchronisation de signal sur le sous-signal d'horloge de huitième fréquence via l'au moins une DFF dans la huitième unité de synchronisation (2028),
en réponse à la huitième instruction de synchronisation et sur la base du signal de synchronisation global, afin d'obtenir un huitième sous-signal d'horloge synchronisé, dans lequel le signal d'horloge synchronisé comprend le huitième sous-signal d'horloge synchronisé ; et
la puce FPGA (208) est configurée pour recevoir un signal de données transmis par le canal ADC (205) sous la commande du huitième sous-signal d'horloge synchronisé.

11. Système de synchronisation d'horloge selon la revendication 1, dans lequel :
le système comprend en outre un châssis, les N convertisseurs inter numérique-analogique comprennent P paires d'AWG et Q paires de DAQ, chaque paire d'AWG comprend deux AWG, chaque paire de DAQ comprend deux DAQ, et Q et P sont tous deux des entiers supérieurs ou égaux à 1 ;
le QCP (10), les P paires d'AWG et les Q paires de DAQ sont tous disposés à l'intérieur du châssis ;
les AWG de chaque paire sont disposés symétriquement par rapport au QCP (10) ; et
les DAQ de chaque paire sont disposées symétriquement par rapport au QCP (10).

12. Système de synchronisation d'horloge selon la revendication 1, dans lequel :
les N convertisseurs inter numérique-analogique (20) comprennent un AWG et une DAQ, l'AWG comprend un canal DAC, et la DAQ comprend un canal ADC ;
le QCP (10) est en outre configuré pour charger un fichier de code pour des puces FPGA, dans lequel le fichier de code comprend un premier paramètre de registre, un deuxième paramètre de registre, un troisième paramètre de registre et un quatrième paramètre de registre ;
l'AWG est configuré pour écrire le premier paramètre de registre dans le module de conversion de fréquence dans l'AWG ;
la DAQ est configurée pour écrire le deuxième paramètre de registre dans le module de conversion de fréquence dans la DAQ ;
l'AWG est en outre configuré pour écrire le troisième paramètre de registre dans le canal DAC dans l'AWG ; et
la DAQ est en outre configurée pour écrire le quatrième paramètre de registre dans le canal ADC dans la DAQ.

13. Procédé pour commander une synchronisation de signal, appliqué à un système de synchronisation d'horloge, dans lequel le système comprend un processeur de commande quantique, QCP, et N convertisseurs inter numérique-analogique, chaque convertisseur inter numérique-analogique comprend un module de conversion de fréquence et un module de synchronisation de signal, le module de synchronisation de signal comprend au moins une bascule D, DFF, et N étant un entier supérieur à 1 ;
dans lequel le procédé comprend les étape suivantes :
générer (401), par le QCP, un signal de synchronisation global et N signaux d'horloge de référence, dans lequel chaque signal d'horloge de référence correspond à l'un des convertisseurs inter numérique-analogique ;
transmettre (402), par le QCP, le signal de synchronisation global et chaque signal d'horloge de référence au module de conversion de fréquence dans le convertisseur inter numérique-analogique correspondant ;
transmettre (402), par le QCP, le signal de synchronisation global au module de synchronisation de signal dans chaque convertisseur inter numérique-analogique ;
effectuer (403), par le module de conversion de fréquence, une conversion de fréquence sur le signal d'horloge de référence reçu afin d'obtenir un signal d'horloge cible ;
générer (403), par le module de conversion de fréquence, une instruction de synchronisation de signal selon le signal de synchronisation global reçu ;
transmettre (404), par le module de conversion de fréquence, l'instruction de synchronisation de signal et le signal d'horloge cible au module de synchronisation de signal ; et
stabiliser, par le module de synchronisation de signal, le signal de synchronisation global via l'au moins une DFF en utilisant le signal d'horloge cible, et effectuer (405), par le module de synchronisation de signal, une synchronisation de signal sur le signal d'horloge cible sur la base du signal stabilisé pour une synchronisation globale en réponse à l'instruction de synchronisation de signal afin d'obtenir un signal d'horloge synchronisé.

14. Support de stockage lisible par ordinateur stockant un programme informatique, dans lequel le programme informatique comprend des instructions qui, lorsqu'elles sont exécutées sur un ordinateur, configurent l'ordinateur pour qu'il effectue le procédé selon la revendication 13.

15. Produit de programme informatique comprenant des instructions, dans lequel les instructions, lorsqu'elles sont exécutées sur un ordinateur, configurent l'ordinateur pour qu'il effectue le procédé selon la revendication 13.
